# EUROPÄISCHE PATENTSCHRIFT

(11) **EP 4 390 110 B1**
(45) Veröffentlichungstag und Bekanntmachung des Hinweises auf die Patenterteilung: **15.04.2026**
(21) Anmeldenummer: 22214731.6
(22) Anmeldetag: 19.12.2022
(51) Int. Cl.: F03D 1/06

(54) **ROTORBLATT EINER WINDENERGIEANLAGE, WINDENERGIEANLAGE UND ZUGEHÖRIGES VERFAHREN**
ROTOR BLADE OF A WIND TURBINE, WIND TURBINE AND CORRESPONDING METHOD
PALE DE ROTOR D'UNE ÉOLIENNE, ÉOLIENNE ET PROCÉDÉ ASSOCIÉ

(43) Veröffentlichungstag der Anmeldung: 26.06.2024
(73) Patentinhaber: Wobben Properties GmbH, 26607 Aurich (DE)
(72) Erfinder: Bekiropoulos, Dimitrios, 26607 Aurich (DE); Scheit, Christoph, 26607 Aurich (DE); Stemberg, Jochen, 26607 Aurich (DE)
(74) Vertreter: Eisenführ Speiser

(56) Entgegenhaltungen:
- US-A1- 2012 027 590
- US-A1- 2015 050 154
- US-A1- 2019 078 549
- US-A1- 2022 163 012

## Beschreibung

Die Erfindung betrifft ein Rotorblatt einer Windenergieanlage, eine Windenergieanlage mit einem Rotorblatt und ein Verfahren zur Optimierung eines Rotorblatts.

Windenergieanlagen sind bekannt, sie erzeugen elektrische Leistung aus Wind. Windenergieanlagen betreffen in der Regel sogenannte Horizontalachsen-Windenergieanlagen, bei denen die Rotorachse im Wesentlichen horizontal angeordnet ist und die Rotorblätter eine im Wesentlichen senkrechte Rotorfläche überstreichen. Windenergieanlagen umfassen neben einem an einer Gondel angeordneten Rotor in der Regel einen Turm, auf dem die Gondel mit dem Rotor um eine im Wesentlichen vertikal ausgerichtete Achse drehbar angeordnet ist. Der Rotor umfasst in der Regel ein, zwei oder mehrere gleich lange Rotorblätter. Die Rotorblätter sind schlanke Bauteile, die häufig aus faserverstärktem Kunststoff hergestellt sind.

Die Formgebung der Außenkontur der Rotorblätter wird üblicherweise durch die Aneinanderreihung unterschiedlicher Profilschnitte definiert. Ein Rotorblatt umfasst in der Regel eine Mehrzahl unterschiedlicher Profilschnitte. Die Profilschnitte sollen an den verschiedenen Radiuspositionen eines Rotorblatts einen im Wesentlichen aerodynamisch optimalen Strömungsverlauf ermöglichen. Trotz der stetigen aerodynamischen Optimierungen an Rotorblättern ist festzustellen, dass eine Vielzahl von Windenergieanlagen von Menschen wahrnehmbare Geräusche emittieren. Die von Windenergieanlagen emittierten Geräusche sind unter anderem durch aerodynamische Effekte an den Hinterkanten der Rotorblätter bedingt. Diese auch als Hinterkantenlärm bezeichnete Geräuschemission stellt eine Einschränkung bei der aerodynamischen Auslegung dar. Zur Reduktion der Geräuschemission wird beispielsweise die Drehzahl einer Windenergieanlage reduziert. Das bedeutet unter anderem, dass zur Reduktion der Geräuschemission die Anlagenleistung reduziert wird. Dies resultiert in einer niedrigeren Wirtschaftlichkeit der Windenergieanlage.

Zur Reduktion des Hinterkantenlärms ist es bekannt, sogenannte "Trailing Edge Serrations" oder "Finlets" einzusetzen. Trailing Edge Serrations sind gezackte Profilelemente, die an der Hinterkante von Rotorblättern angeordnet werden. Finlets hingegen sind gering dimensionierte, an der Hinterkante angebrachte, vertikal zur Rotorblattoberfläche ausgerichtete Flügel, die spannweitige Druckfluktuation reduzieren. Die existierenden Vorrichtungen und Verfahren zur Reduktion des Hinterkantenlärms bieten verschiedene Vorteile, jedoch sind weitere Verbesserungen wünschenswert.

US 2015/0050154 A1 beschreibt einen Steg, der entlang einer Hinterkante eines Tragflügels zur Lärmreduzierung angeordnet ist. Die Seiten des Steges konvergieren von den jeweiligen Saug- und Druckseiten der Hinterkante zu einer nach hinten weisenden Spitze des Steges zusammen. Die Seiten des Steges können konkav sein. Der Steg kann hohl sein oder einen Kern aus schallabsorbierendem Material aufweisen. Die Seiten des Steges können zum Druckausgleich über den Steg perforiert sein. Der Steg kann mit Borsten bedeckt sein oder durch die Spitzen von Borsten unterschiedlicher Länge definiert sein. Die Spitze des Grats und/oder mindestens eine Ecke des Steges und/oder der Hinterkante können gezahnt ausgebildet sein.

US 2022/163012 A1 beschreibt eine Rotorblattanordnung für Windkraftanlagen mit einem Rotorblatt und einem Geräuschminderer, der an dem Rotorblatt angeordnet ist. Der Geräuschminderer umfasst eine Vielzahl von ausgerichteten Gratelementen, wobei jedes Gratelement eine Länge aufweist und einen ersten Abschnitt umfasst, der sich entlang eines ersten Teils der Länge des Gratelements erstreckt, und einen zweiten Abschnitt, der sich entlang eines zweiten Teil der Länge des Gratelements erstreckt, wobei der erste Abschnitt eine höhere Steifigkeit aufweist als der zweite Abschnitt.

Vor diesem Hintergrund war es eine Aufgabe der vorliegenden Erfindung, eine Reduktion des Hinterkantenlärms von Rotorblättern zu ermöglichen.

Gemäß einem ersten Aspekt wird diese Aufgabe gelöst durch ein Rotorblatt einer Windenergieanlage gemäß Anspruch 1,.

Das Rotorblatt erstreckt sich in Richtung der Rotorblattlänge, der Profiltiefe und der Profildicke. In Richtung der Rotorblattlänge erstreckt sich das Rotorblatt vorzugsweise zwischen einer Rotorblattwurzel und einer Rotorblattspitze. Die Profiltiefe ist insbesondere orthogonal zu der Rotorblattlänge ausgerichtet. Im Betrieb ist die Rotorblatttiefe im Wesentlichen parallel zur Anströmrichtung des Rotorblatts ausgerichtet. Orthogonal zu der Richtung der Rotorblattlänge und der Profiltiefe erstreckt sich das Rotorblatt in Richtung der Profildicke. Die Profiltiefe und die Profildicke spannen im Wesentlichen an jeder Position entlang der Rotorblattlänge ein aerodynamisches Profil, das auch als Profilschnitt verstanden werden kann, auf.

Das Rotorblatt umfasst das mindestens eine Profilelement. Das mindestens eine Profilelement weist den proximalen Abschnitt und den distalen Abschnitt auf. Der proximale Abschnitt des mindestens einen Profilelements ist insbesondere dadurch gekennzeichnet, dass dieser nicht von der Hinterkante auskragt, sondern an dem Hinterkantenbereich angeordnet ist. Der distale Abschnitt des mindestens einen Profilelements ist dadurch gekennzeichnet, dass dieser von der Hinterkante in Auskragrichtung auskragt.

Der Hinterkantenbereich umfasst vorzugsweise einen Bereich, welcher sich ausgehend von der Hinterkante bis zu einer Distanz von 20% der lokalen Profilsehne, bevorzugt bis zu einer Distanz von 5% der lokalen Profilsehne, besonders bevorzugt bis zu einer Distanz von 1% der lokalen Profilsehne, ausstreckt. Somit erstreckt sich der Hinterkantenbereich auf die Druckseite und auf die Saugseite des Rotorblatts.

Die Auskragrichtung des mindestens einen Profilelements an einer gegebenen Position entlang der Rotorblattlänge ist, für diese Position, gegeben durch die Verbindung von dem Punkt, wo die Profilsehne die Hinterkante schneidet zu dem Punkt des Profilelements der sich, an dieser Position, am weitesten entfernt von der Hinterkante befindet, wobei hier nur der Teil des mindestens einen Profilelements berücksichtigt wird, welcher sich in Richtung der Profilsehne hinter der Hinterkante befindet, daher also der distale Abschnitt.

Die Auskragrichtung ist im Wesentlichen parallel zur Richtung der Profiltiefe ausgerichtet. Im Wesentlichen parallel zur Richtung der Profiltiefe bedeutet insbesondere, dass sich zwischen der Auskragrichtung und der Richtung der Profiltiefe ein Winkel von bevorzugt weniger als 30°, weniger als 15°, weniger als 10° oder besonders bevorzugt weniger als 5° einstellt.

Die Profilelementdicke erstreckt sich in einer Richtung senkrecht zur Auskragrichtung zwischen einer Ebene, welche von der Hinterkante und der Auskragrichtung aufgespannt wird, und der Oberfläche des mindestens einen Profilelements. Die Profilelementdicke ist in beiden möglichen Richtungen als eine positive Größe zu verstehen.

Ein lokales Minimum der Profilelementdicke des Querschnitts des mindestens einen Profilelements ist zu verstehen als ein Punkt des Querschnitts, welcher eine Profilelementdicke in einer Richtung senkrecht zur Auskragrichtung, aufweist, die kleiner ist als die Profilelementdicke beiderseitig des lokalen Minimums. Beiderseitig des lokalen Minimums bezieht sich auf die zwei Punkte welche im Querschnitt direkt neben dem lokalen Minimum liegen, wobei die Punkte, welche dieselbe Profilelementdicke aufweisen als die des lokalen Minimums, nicht berücksichtigt werden und in diesem Fall der nächste Punkt berücksichtigt wird, welcher eine Profilelementdicke aufweist, die nicht gleich der des lokalen Minimums ist.

Der Erfindung liegt die Erkenntnis zugrunde, dass ein Rotorblatt mit dem mindestens einen Profilement, wobei der Querschnitt des mindestens einen Profilelements mindestens ein lokales Minimum der Profilelementdicke aufweist, eine verbesserte Geräuschemission aufweist. Die Erfinder haben herausgefunden, dass mit dem mindestens einen Profilelement die Abströmungscharakteristik des Rotorblatts verbessert wird. Das im Vorherigen beschriebene mindestens eine Profilelement bricht die turbulenten Strukturen in der Grenzschicht auf. Darüber hinaus wird durch das mindestens eine Profilelement die Richtcharakteristik der dominanten Schallquellen insofern verändert, als die Schallquelle diffuser abstrahlt und idealerweise weniger Geräusche an der für die Schallleistungsvermessung vorgeschriebenen Messposition der Windenergieanlage ankommen. An dieser Messposition tritt bisher, bedingt durch die dipol-ähnliche Abstrahlcharakteristik des Hinterkantenlärms, üblicherweise ein Maximum des Schallleistungspegels auf.

Das im Vorherigen beschriebene mindestens eine Profilelement kann mit geringem Aufwand an einem Rotorblatt, auch an einem Rotorblatt, welches bereits an einem Rotor montiert ist, angeordnet werden. Somit eignet sich das im Vorherigen beschriebene mindestens eine Profilelement auch als eine Nachrüstlösung für Bestandsanlagen.

Gemäß einer bevorzugten Ausführung des Rotorblatts weist das mindestens eine Profilelement mehrere Querschnitte an unterschiedlichen Positionen in einer Richtung parallel zur Auskragrichtung auf, wobei jeder der mehreren Querschnitte jeweils mindestens ein lokales Minimum der Profilelementdicke aufweist, die auf einer Linie liegen, wobei die Verbindung aller lokalen Minima die auf einer Linie liegen als Rille bezeichnet wird, und wobei jeder der mehreren Querschnitte jeweils mindestens ein lokales Maximum der Profilelementdicke aufweist, die auf einer Linie liegen, wobei die Verbindung aller lokalen Maxima, die auf einer Linie liegen, als Gratlinie bezeichnet wird.

Wenn die mehreren Querschnitte jeweils, oder auch nur einige der Querschnitte, ein oder mehr lokale Minima der Profilelementdicke aufweisen, so ist zu verstehen, dass ein oder mehr lokale Minima jeweils auf einer anderen Rille liegen können. Beispielsweise, wenn alle oder mehrere Querschnitte je zwei lokale Minima der Profilelementdicke aufweisen, so können diese auf einer, zwei oder mehr Rillen liegen, wenn die jeweiligen lokalen Minima in Auskragrichtung nicht entlang des gesamten mindestens einen Profilelements vorhanden sind. Wenn, beispielsweise, alle oder mehrere Querschnitte je zwei lokale Minima der Profilelementdicke aufweisen und die jeweiligen lokalen Minima in Auskragrichtung entlang des gesamten mindestens einen Profilelements vorhanden sind, so liegen die je zwei lokalen Minima der Profilelementdicke der allen oder mehreren Querschnitte auf zwei Rillen.

Wenn die mehreren Querschnitte jeweils, oder auch nur einige der Querschnitte, ein oder mehr lokale Maxima der Profilelementdicke aufweisen so ist zu verstehen, dass die ein oder mehr lokale Maxima jeweils auf einer anderen Gratlinie liegen können. Beispielsweise, wenn alle oder mehrere Querschnitte je zwei lokale Maxima der Profilelementdicke aufweisen, so können diese auf einer, zwei oder mehr Gratlinien liegen, wenn die jeweiligen lokalen Maxima nicht entlang, in Auskragrichtung, des gesamten mindestens einen Profilelements vorhanden sind. Wenn, beispielsweise, alle oder mehrere Querschnitte je zwei lokale Maxima der Profilelementdicke aufweisen und die jeweiligen lokalen Maxima entlang, in Auskragrichtung, des gesamten mindestens einen Profilelements vorhanden sind, so liegen die je zwei lokalen Maxima der Profilelementdicke der gesamten oder mehreren Querschnitte auf zwei Gratlinien.

Die Oberfläche des mindestens einen Profilelements kann eine abgerundete oder eine Kantenform auf einer Gratlinie und/oder einer Rille offenbaren.

Gemäß einer vorteilhaften Ausführung des Rotorblatts, weist das mindestens eine Profilelement für jede Rille eine Profilfläche auf, welche sich auf der Rotorblattwurzelseite der jeweiligen Rille befindet und sich zwischen derjeweiligen Rille und der Gratlinie, welche sich auf derselben Profilseite direkt auf der Rotorblattwurzelseite der jeweiligen Rille befindet, erstreckt, wobei die Profilfläche eine in Richtung der Rotorblattspitzenseite abnehmende Profilelementdicke aufweist, und eine Profilfläche, welche sich auf der Rotorblattspitzenseite der jeweiligen Rille befindet und sich zwischen der jeweiligen Rille und der Gratlinie, welche sich auf derselben Profilseite direkt auf der Rotorblattspitzenseite der jeweiligen Rille befindet, erstreckt, wobei die Profilfläche eine in Richtung der Rotorblattspitzenseite zunehmende Profilelementdicke aufweist, wobei jede Profilfläche konvex, konkav oder gerade ausgebildet ist.

Die Beschreibung der Profilfläche als konvex, konkav oder gerade ist makroskopisch zu verstehen. Damit ist gemeint, dass eine Profilfläche die konvex, konkav oder gerade ausgebildet ist und nur in kleinen Abschnitten davon abweicht, als konvexe, konkave oder gerade Profilfläche zu verstehen ist.

Eine Profilfläche welche beispielsweise wellenförmig ausgebildet ist und dennoch eine im gesamten gesehen konkave Form offenbart, wird als eine konkave Profilsehne verstanden. Eine gerade Fläche bedeutet, dass die gesamte Fläche flach ist.

Eine Rille muss nicht über die ganze Länge, in Auskragrichtung, des Profilelementes vorhanden sein, sie kann sich beispielsweise über 50% oder einen beliebiegen anderen Anteil der Länge des Profilelements erstrecken.

Gemäß einer weiteren bevorzugten Ausführung weist das mindestens eine Profilelement auf der druckseitigen Profilseite und/oder auf der saugseitigen Profilseite, angefangen von einer Rotorblattwurzelseite, eine erste Profilfläche auf, wobei die erste Profilfläche eine in Richtung der Rotorblattspitzenseite zunehmende Profilelementdicke aufweist und wobei die erste Profilfläche ihre maximale Profilelementdicke entlang einer ersten Gratlinie, welche parallel zur Profilsehne verläuft, erreicht, wobei jede Profilfläche konvex, konkav oder gerade ausgebildet ist.

Gemäß einer bevorzugten Ausführung des Rotorblatts weist das mindestens eine Profilelement auf der druckseitigen Profilseite und/oder auf der saugseitigen Profilseite, angefangen von einer Rotorblattwurzelseite, auf der Rotorblattspitzenseite der letzten Gratlinie, in Richtung der Rotorblattspitzenseite, eine letzte Profilfläche auf, wobei die letzte Profilfläche eine in Richtung des Rotorblattspitzenendes abnehmende Profilelementdicke aufweist und wobei die letzte Profilfläche ihre minimale Profilelementdicke entlang dem Rand des mindestens einen Profilelements erreicht, wobei jede Profilfläche konvex, konkav oder gerade ausgebildet ist.

Gemäß einer besonders bevorzugten Ausführung des Rotorblatts erstreckt sich jede Profilfläche des mindestens einen Profilelements von einem distalen Ende hin zu einem proximalen Ende des mindestens einen Profilelements.

Gemäß einer bevorzugten Ausführung des Rotorblatts ist jede Profilfläche des mindestens einen Profilelements, welche an eine Rille angrenzend ist, im Wesentlichen kongruent zu der zweiten Profilfläche, welche an dieselbe Rille angrenzend ist, ausgebildet.

Eine Fläche ist kongruent zu einer zweiten Fläche, wenn die zweite Fläche, anhand einer Parallelverschiebung, Drehung, Spiegelung oder einer Verknüpfung dieser Operationen aus der ersten Fläche erhalten werden kann.

Gemäß einer bevorzugten Ausführung des Rotorblatts weist mindestens eine Gratlinie des mindestens einen Profilelements eine scharfe Kante auf.

Eine scharfe Kante ist vorhanden, wenn der minimale Durchmesser eines Kreises, welcher für verschiedene gegebene Höhen der Mitte des Kreises beide Flächen, die die Kante bilden, auf derselben Höhe wie die Mitte des Kreises berührt und bevorzugt zweimal kleiner ist als die Distanz von der Mitte des Kreises bis zur Kante, besonders bevorzugt fünfmal kleiner ist als die Distanz von der Mitte des Kreises bis zur Kante, am meisten bevorzugt zehnmal kleiner ist als die Distanz von der Mitte des Kreises bis zur Kante. Diese Bedingung muss bevorzugt für die letzten 2%, besonders bevorzugt für die letzten 10%, am meisten bevorzugt für die letzten 30% der Höhe der Kante erfüllt sein, wobei diese Höhe senkrecht zur Auskragrichtung von der Rotorblattoberfläche zur Kante gemessen wird.

Eine scharfe Kante hat den Vorteil, dass sie Luftströmungen, welche nicht parallel zu dieser scharfen Kante verlaufen, ablenkt.

Gemäß einer bevorzugten Ausführung des Rotorblatts weist mindestens eine Rille des mindestens einen Profilelements eine scharfe Kante auf.

Analog zu der Definition der scharfen Kante für die Gratlinie ist eine solche auch für die Rille gemäß dieser Ausführung zu verstehen.

Gemäß einer bevorzugten Ausführung des Rotorblatts ist jede Gratlinie und jede Rille der druckseitigen Profilseite des mindestens einen Profilelements in jedem Punkt senkrecht in Bezug auf die Auskragrichtung, unter der jeweiligen Gratlinie beziehungsweise jeweiligen Rille der saugseitigen Profilseite des mindestens einen Profilelements angeordnet.

Erfindungsgemäß ist die druckseitige Profilseite des mindestens einen Profilelements eine Spiegelung der entsprechenden saugseitigen Profilseite in Bezug auf die Ebene, welche von der Hinterkante und der Auskragrichtung aufgespannt wird.

Erfindungsgemäß sind der proximale Abschnitt und der distale Abschnitt des mindestens einen Profilelements pfeilspitzenförmig ausgebildet, wobei das proximale Ende und das distale Ende jeweils im Wesentlichen rund oder spitz ausgebildet sind, beispielsweise das proximale Ende spitz und das distale Ende rund.

Hierbei sollte beachtet werden, dass das Profilelement auch mehrere in Rotorblattlängsrichtung nebeneinanderliegende pfeilspitzenförmige Enden aufweisen kann.

Wenn, beispielsweise, das distale Ende rund und das proximale Ende spitz ist, ergibt sich eine Tropfenform für das Profilelement, wobei hier das Profilelement als Ganzes betrachtet wird. Eine Tropfenform ist solange eines der Enden, hier das proximale Ende, spitz ist, ebenfalls als pfeilspitzenförmig im Sinne der Erfindung zu verstehen.

Gemäß einer bevorzugten Ausführung des Rotorblatts besteht der proximale Abschnitt und der distale Abschnitt des mindestens einen Profilelements aus mehreren parallel angeordneten Pfeilspitzenformen. Jede der Pfeilspitzenformen grenzt an die direkt benachbarte Pfeilspitzenform an, insbesondere überschneiden bzw. überlappen sich die jeweiligen Profile. Das bedeutet, dass die jeweils benachbarten Pfeilspitzenformen im Vergleich zu vereinzelten Pfeilspitzenformen eine seitlich abgeschnitten wirkende Kontur aufweisen kann. Für die Form der jeweiligen proximalen und distalen Enden ist das seitliche Abschneiden jedoch unerheblich.

Als Pfeilspitzenform ist jegliche Form zu verstehen, welche als Spitze eines Pfeils verwendet werden kann. Eine Pfeilspitzenform ergibt sich insbesondere dadurch, dass das Profilelement an dieser Stelle bzw. diesen nebeneinander liegenden Stellen nadelspitz ausläuft, wobei der Querschnitt der Pfeilspitze nicht eingeschränkt ist und beispielsweise rund, dreieckig, viereckig, achteckig oder anderweitig geformt ausgebildet ist.

Die mehreren parallel angeordneten Pfeilspitzenformen weisen an den jeweiligen Stellen, an denen die benachbarten Pfeilspitzenformen überlagern bzw. aneinander angeordnet sind, vorzugsweise eine Rille im Sinne der Erfindung auf.

In beiden Fällen, für die runden und die spitzen Enden, sind die Flächen, welche die runden oder spitzen Enden formen, konvex, konkav oder gerade. Vorzugsweise ist jedes Ende anhand von zwei, insbesondere senkrecht zu der Auskragrichtung durch eine Gratlinie getrennte, Flächen geformt, wobei jede einzelne Fläche konkav, konvex oder gerade ist.

Die beiden Flächen sind also sowohl saugseitig als auch druckseitig ausgebildet und definieren die Kontur des Profilelementes, insbesondere die Profilelementdicke.

Gemäß einer bevorzugten Ausführung des Rotorblatts ist zwischen der druckseitigen Profilseite und der saugseitigen Profilseite im proximalen Abschnitt ein Befestigungsspalt ausgebildet, wobei der Hinterkantenbereich zumindest teilweise, vorzugsweise vollständig innerhalb des Befestigungsspalts angeordnet ist.

Der Befestigungsspalt ist vorzugsweise derart ausgebildet, dass das mindestens eine Profilelement mittels des Befestigungsspalts auf den Hinterkantenbereich des Rotorblatts aufgeschoben werden kann. Vorzugsweise kann das Profilelement in dieser Position verklebt werden. Vorzugsweise verläuft innerhalb des Befestigungsspalts eine Ebene, die als Spiegelebene der druckseitigen Profilseite und der saugseitigen Profilseite wirkt.

Gemäß einer bevorzugten Ausführung des Rotorblatts ist das mindestens eine Profilelement zweiteilig ausgebildet, wobei ein erster Teil die druckseitige Profilseite und ein zweiter Teil die saugseitige Profilseite aufweist, wobei der erste Teil an der Druckseite und der zweite Teil an der Saugseite befestigt ist, vorzugsweise durch Kleben, wobei vorzugsweise die von der Hinterkante auskragenden Abschnitte des ersten Teils und des zweiten Teils miteinander befestigt, vorzugsweise verklebt, sind.

Eine zweiteilige Ausbildung des mindestens einen Profilelements vereinfacht die Herstellung des mindestens einen Profilelements durch Verringerung der Komplexität.

Gemäß einer bevorzugten Ausführung des Rotorblatts stellt sich zwischen der druckseitigen Profilseite und der saugseitigen Profilseite des mindestens einen Profilelements die Elementdicke ein, wobei die Elementdicke von dem proximalen Ende hin zu einer maximalen Elementdicke an einer Profilelementstelle ansteigt und die Elementdicke von dieser Profilelementstelle hin zum distalen Ende hin abnimmt.

Gemäß einer bevorzugten Ausführung des Rotorblatts umfasst das Rotorblatt zwei oder mehr Profilelemente, die entlang der Hinterkante benachbart zueinander angeordnet sind und aneinanderstoßen.

In einem zweiten Aspekt wird eine Windenergieanlage, welche mindestens ein Rotorblatt gemäß dem ersten Aspekt der vorliegenden Offenbarung oder eine bevorzugte Ausgestaltung des Rotorblatts umfasst, offenbart.

Die Windenergieanlage kann eine beliebige Anzahl an Rotorblättern umfassen die größer gleich eins ist, wobei mindestens eines der Rotorblättern das Rotorblatt gemäß der Offenbarung oder eine bevorzugte Ausgestaltung des Rotorblatts umfasst.

In einem dritten Aspekt wird ein Windpark offenbart, welcher mehrere Windenergieanlagen umfasst, wobei mindestens eine dieser Windenergieanlagen gemäß dem zweiten Aspekt der vorliegenden Offenbarung ausgebildet ist.

In einem vierten Aspekt wird ein Verfahren zum Optimieren eines Rotorblatts gemäß Anspruch 18 offenbart.

Der Zeitpunkt, an welchem der Schritt des Montierens des mindestens einen Profilelements stattfindet, ist nicht ausschlaggebend. Der Schritt des Montierens des mindestens einen Profilelements kann vor der Inbetriebnahme des Rotorblatts sowie auch nach der Inbetriebnahme des Rotorblatts stattfinden.

Weitere Vorteile und besondere Ausgestaltungen werden nachfolgend mit Verweis auf die beigefügten Fig. beschrieben. Hierbei zeigen:
- Fig. 1:: eine schematische, dreidimensionale Ansicht einer beispielhaften Ausführungsform einer Windenergieanlage;
- Fig. 2 - 4:: schematische, dreidimensionale Detailansichten eines Rotorblatts;
- Fig. 5:: eine schematische, dreidimensionale Ansicht eines Profilelements;
- Fig. 6:: eine schematische, zweidimensionale Querschnittsansicht des in Fig. 5 gezeigten Profilelements;
- Fig. 7:: eine schematische, zweidimensionale Querschnittsansicht eines Profilelements;
- Fig. 8:: eine schematische, zweidimensionale Draufsicht auf das in Fig. 5 gezeigte Profilelement;
- Fig. 9:: eine schematische, zweidimensionale Seitenansicht des in Fig. 5 gezeigten Profilelements;
- Fig. 10 - 16:: schematische, zweidimensionale Draufsichten alternativer Ausführungen des in Fig. 5 gezeigten Profilelements;
- Fig. 17 - 22:: schematische, zweidimensionale Seitenansichten alternativer Ausführungen des in Fig. 5 gezeigten Profilelements;
- Fig. 23:: eine schematische, dreidimensionale Ansicht von dem Profilelement welches benachbart zueinander angeordneten Pfeilspitzenformen offenbart;
- Fig. 24:: eine weitere schematische Ansicht von dem Profilelement welches benachbart zueinander angeordneten Pfeilspitzenformen offenbart, wobei jede Pfeilspitzenform mehrere Rillen und Gratlinien offenbart;
- Fig. 25:: ein schematisches Verfahren.

In den Fig. sind gleiche oder im Wesentlichen funktionsgleiche bzw. -ähnliche Elemente mit den gleichen Bezugszeichen bezeichnet.

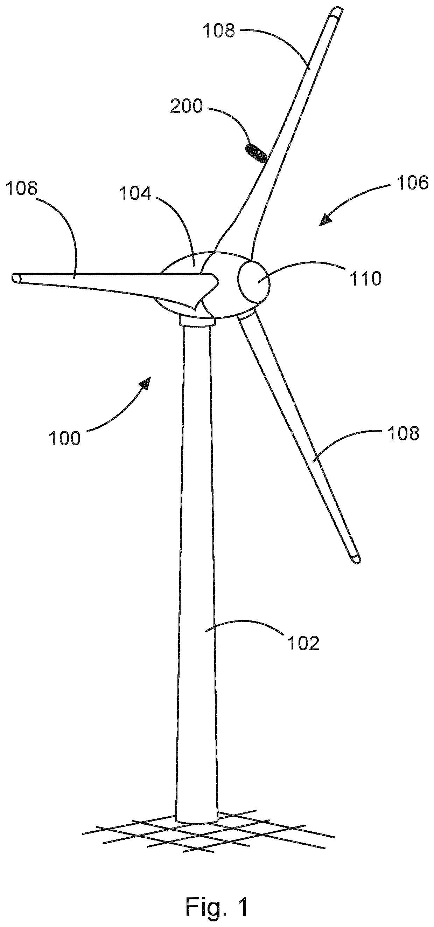

Fig. 1 zeigt eine schematische, dreidimensionale Ansicht einer Windenergieanlage 100. Die Windenergieanlage 100 weist einen Turm 102 und eine Gondel 104 auf dem Turm 102 auf. An der Gondel 104 ist ein aerodynamischer Rotor 106 mit drei Rotorblättern 108 und einem Spinner 110 vorgesehen. Der aerodynamische Rotor 106 wird im Betrieb der Windenergieanlage 100 durch den Wind in eine Drehbewegung versetzt und dreht somit auch einen elektrodynamischen Rotor oder Läufer eines Generators, welcher direkt oder indirekt mit dem aerodynamischen Rotor 106 gekoppelt ist. Der elektrische Generator ist in der Gondel 104 angeordnet und erzeugt elektrische Energie.

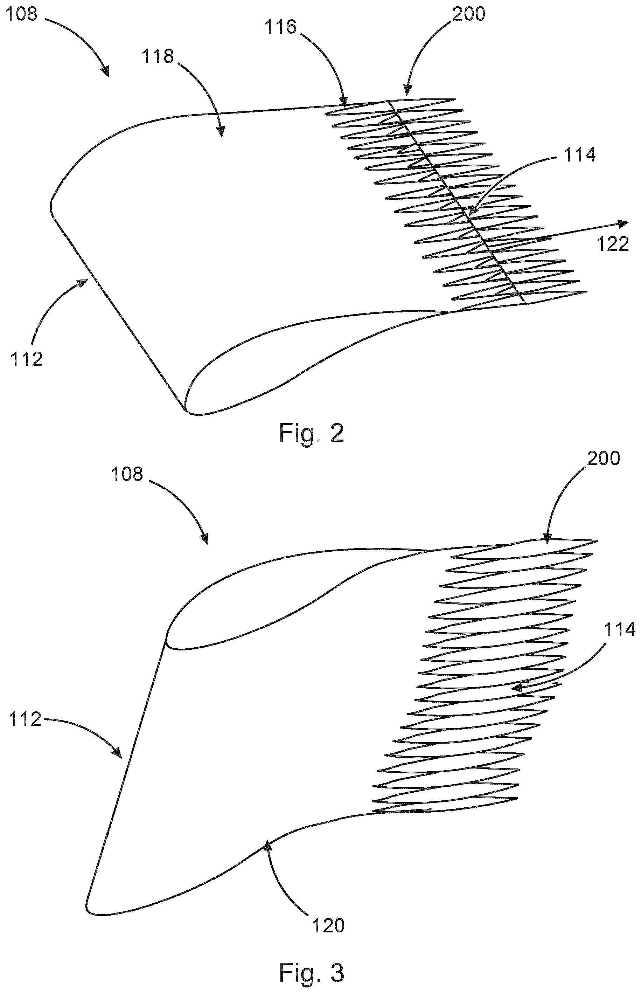

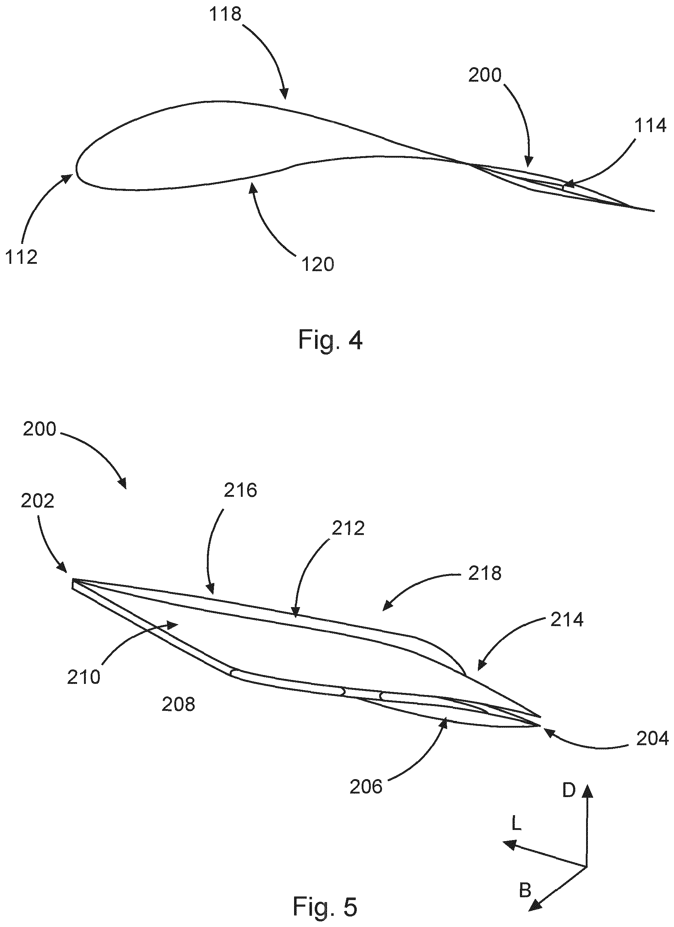

An mindestens einem der Rotorblätter 108 ist mindestens ein Profilelement 200 angeordnet. Das mindestens eine Profilelement 200 ist mit einem proximalen Abschnitt 214 an einem Hinterkantenbereich 116 angrenzend an die Hinterkante 114 des Rotorblatts 108 angeordnet und kragt mit einem distalen Abschnitt 216 von der Hinterkante 114 mit einer Auskragrichtung 122 aus, wie beispielsweise in Fig. 2 und Fig. 5 ersichtlich ist. Das mindestens eine Profilelement 200 weist im Wesentlichen orthogonal zu der Auskragrichtung 122 einen Querschnitt auf, wobei der Querschnitt des mindestens einen Profilelements 200 mindestens ein lokales Minimum der Profilelementdicke aufweist, wobei die Profilelementdicke in dem Querschnitt beiderseitig des lokalen Minimums einen größeren Wert aufweist, wie nachfolgend mit Verweis auf die weiteren Fig. noch verdeutlicht wird.

Die Fig. 2 bis 4 zeigen schematische, dreidimensionale Detailansichten eines Rotorblatts. Zwischen der Saugseite 118 und der in den Fig. 3 und 4 gezeigten Druckseite 120 stellt sich eine Profildicke ein. In Fig. 2 ist ein Abschnitt des Rotorblatts 108 zu sehen mit Blickrichtung, unter einem Winkel, auf die Saugseite 118 des Rotorblatts 108. In Fig. 3 ist ein Abschnitt des Rotorblatts zu sehen mit Sicht, unter einem Winkel, auf die Druckseite 120 des Rotorblatts 108. In Fig. 4 ist ein Querschnitt orthogonal zur Länge des Rotorblatts 108, des Rotorblatts 108 gezeigt.

Fig. 5 zeigt eine schematische, dreidimensionale Ansicht eines pfeilspitzenförmigen Teils des mindestens einen Profilelements 200. Es zeigt also nur einen Ausschnitt des mindestens einen Profilelements 200, wobei das Profilelement 200 bevorzugt wie in Fig. 2 gezeigt mehrere derartige pfeilspitzenförmige Teile nebeneinander angeordnet sind. Die mehreren pfeilspitzenförmigen Elemente sind in einer Breitenrichtung B bzw. Rotorblattlängsrichtung nebeneinander angeordnet. Ähnliche Anbauteile an Hinterkanten werden auch als Trailing Edge Serrations (TES) bezeichnet. Eine bevorzugte Form der Pfeilspitzenform ist die Tropfenform, bei der das proximale oder das distale Ende 202 bzw. 204 nicht spitz, sondern rund zuläuft.

Das mindestens eine Profilelement 200 erstreckt sich von einem distalen Ende 202 hin zu einem proximalen Ende 204. Das mindestens eine Profilelement 200 weist einen proximalen Abschnitt 214 und einen distalen Abschnitt 216 auf. Der proximale Abschnitt 214 ist im bestimmungsgemäßen Betrieb des mindestens einen Profilelements 200 in Richtung der Profildicke, in dem in Fig. 5 gezeigten Koordinatensystem mit Dicke D bezeichnet, zu dem Rotorblatt benachbart angeordnet.

Der distale Abschnitt 216 kragt im bestimmungsgemäßen Betrieb des mindestens einen Profilelements 200 von der Hinterkante 114, also in Längsrichtung L bzw. Profiltiefenrichtung aus. Das mindestens eine Profilelement 200 weist im proximalen Abschnitt 214 einen Befestigungsspalt 206 auf. Der Befestigungsspalt 206 ist angeordnet und ausgebildet, um in diesem einen Abschnitt des Hinterkantenbereichs 116 anzuordnen. Durch den Befestigungsspalt 206 kann das Profilelement 200 an der Hinterkante 114 montiert werden.

Das mindestens eine Profilelement 200 weist ferner eine Gratlinie 208 auf. Die Gratlinie 208 ist vorzugsweise mittig zwischen den Seitenkanten des mindestens einen Profilelements 200 angeordnet. Das mindestens eine Profilelement 200 weist ferner eine erste Profilfläche 210 und eine zweite Profilfläche 212 auf. In der Fig. 5 ist insbesondere die saugseitige Profilseite 218 gezeigt. Die saugseitige Profilseite 218 weist die erste Profilfläche 210 und die zweite Profilfläche 212 auf, die jeweils konkav, konvex oder gerade ausgebildet sind. Die erste Profilfläche 210 und/oder die zweite Profilfläche 212 kann auch abschnittsweise konkav, konvex oder gerade ausgebildet sein, beispielsweise indem ein Übergang von konkav zu konvex ohne lokales Minimum oder Maximum, an der Stelle des Übergangs, vorhanden ist. Die Gratlinie 208 trennt die erste Profilfläche 210 und die zweite Profilfläche 212. Analog weist das Profilelement 200 zwei Profilflächen und eine Gratlinie auf der Druckseite auf.

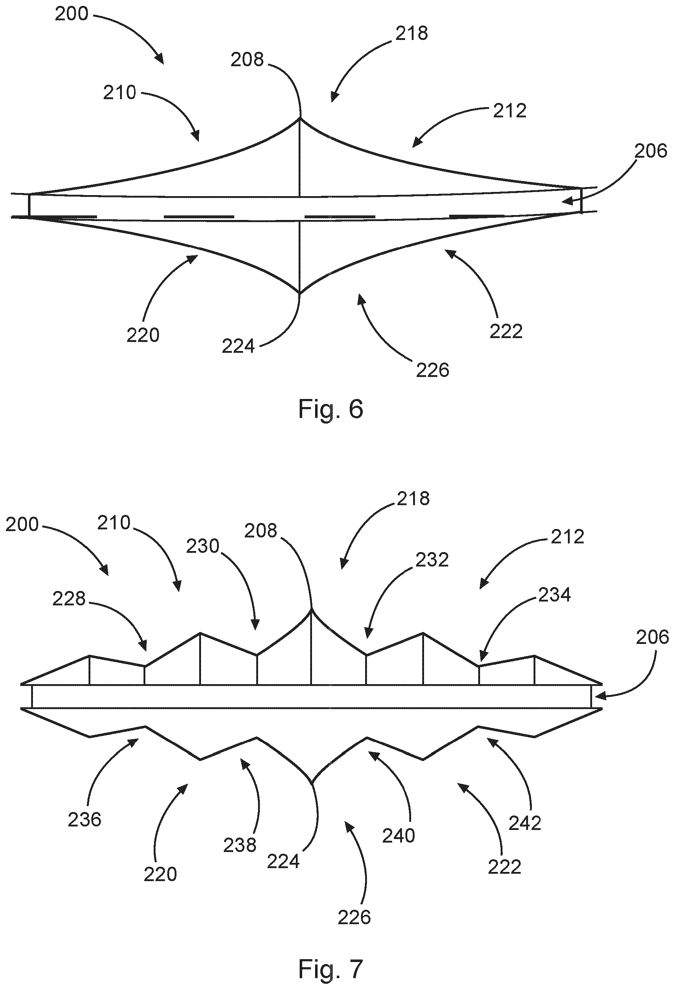

Fig. 6 zeigt eine schematische, dreidimensionale Ansicht eines pfeilspitzenförmigen Teils des mindestens einen Profilelements 200. Es zeigt also nur einen Ausschnitt des mindestens einen Profilelements 200. Das mindestens eine Profilelement 200 ist mit einer Ansicht entlang der Auskragrichtung 122 gezeigt, so dass der Blick in den Befestigungsspalt 206 fällt. Die saugseitige Profilseite 218 weist die erste Profilfläche 210 und die zweite Profilfläche 212 auf, wobei hier beide Profilflächen eine konkave Ausbildung aufweisen, also nach innen gewölbt sind. Die druckseitige Profilseite 226 weist die erste Profilfläche 220 und die zweite Profilfläche 222 auf, wobei hier beide Profilflächen eine konkave Ausbildung aufweisen, also nach innen gewölbt sind. Der Befestigungsspalt 206 ist horizontal entlang des mindestens einen Profilelements 200 zu sehen, wobei der Befestigungsspalt 206 angeordnet und ausgebildet ist, um in dem Befestigungsspalt 206 einen Abschnitt des Hinterkantenbereichs 116 anzuordnen. Fig. 6 zeigt ein zwischen der Druckseite und der Saugseite symmetrisches Profilelement 200, wobei diese Symmetrie nicht in jedem Fall gefordert ist und auch unsymmetrische Ausführungen vorstellbar sind.

Fig. 7 zeigt eine schematische, dreidimensionale Ansicht eines Profilelements 200 mit einer Ansicht entlang der Auskragrichtung 122 ähnlich zu Fig. 6. Die Profilflächen 210, 212, 220, 222 sowohl auf der Druckseite als auch auf der Saugseite sind abgewinkelt, so dass beispielsweise auf der Saugseite vier Rillen 228, 230, 232, 234 zu sehen sind, wobei die Rillen scharfkantig oder alternativ auch in abgerundeter Form, ausgebildet sind. Die Rillen 228, 230, 232, 234 entsprechen einem Minimum in der Dicke des Profilelements 200.

Das Profilelement 200 der Fig. 7 kann als mehrere nebeneinander angeordnete pfeilspitzenförmige Abschnitte wie in Fig. 5 gezeigt aufgefasst werden, die jeweils im Bereich der Rillen 228, 230, 232, 234 aneinanderliegen bzw. überlappen. Durch die "Überlappung" ergibt sich im Bereich der Rillen 228, 230, 232, 234 eine endliche Dicke des Profilelements 200.

Auf der saugseitigen Profilseite 218 sind fünf Gratlinien zu sehen, wobei die Gratlinie in der Mitte der Ansicht mit der Nummer 208 beschriftet ist. Auf der Druckseiten Profilseite 226 sind vier Rillen 236, 238, 240, 242 zu sehen, wobei die Rillen scharfkantig, oder alternativ auch in abgerundeter Form, ausgebildet sind. Auf der druckseitigen Profilseite 226 sind fünf Gratlinien zu sehen, wobei die Gratlinie in der Mitte der Ansicht mit der Nummer 224 beschriftet ist. Auf der saugseitigen Profilseite 218 sowie auf der druckseitigen Profilseite 226 sind jeweils direkt neben jeder Gratlinie je zwei Profilflächen vorhanden.

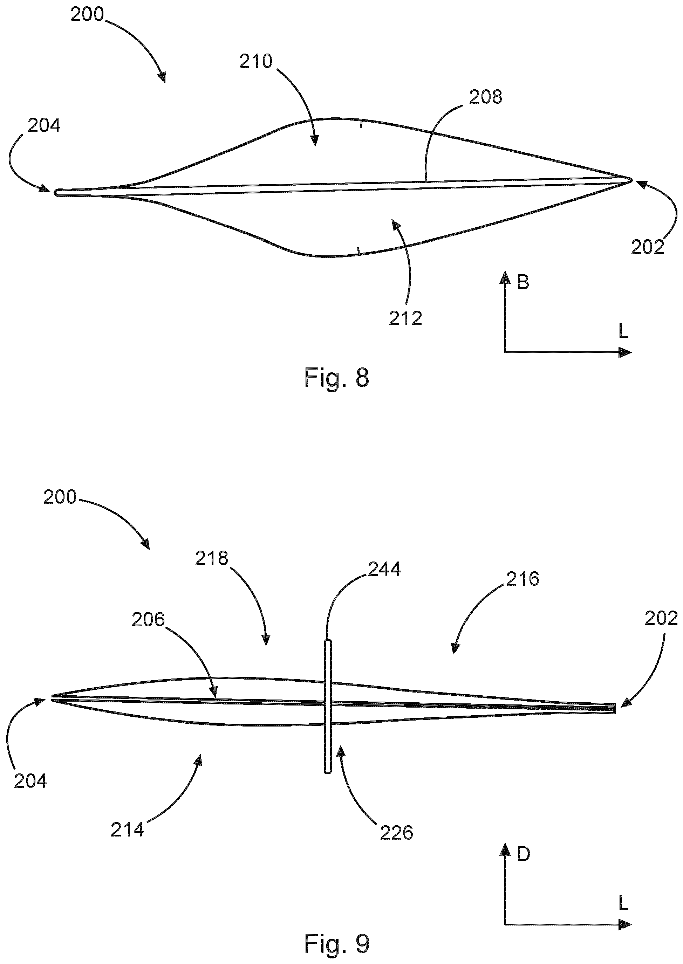

Fig. 8 zeigt eine schematische Ansicht eines einzelnen pfeilspitzenförmigen Teils des mindestens einen Profilelements 200. Das mindestens eine Profilelement 200 ist mit einer Draufsicht, also einer Ansicht mit Blick auf die Saugseite bzw. symmetrisch die Druckseite, gezeigt. Das Koordinatensystem unten rechts zeigt in Richtung der Breite B des mindestens einen Profilelements und in Richtung der Länge L des mindestens einen Profilelements 200, wobei diese Richtungen orthogonal zueinander sind und sich in derselben Ebene befinden.

In Fig. 8 ist eine mögliche geometrische Ausbildung des mindestens einen Profilelements 200 in Richtung der Breite B und der Länge L des mindestens einen Profilelements 200 gezeigt. Das proximale Ende 204 ist spitz ausgebildet. Angefangen von dem proximalen Ende 204 in Richtung des distalen Endes 202, weisen beide Kanten, welche hier in vertikaler Richtung den Rand des mindestens einen Profilelements 200 bilden, eine konkave Form auf bis im Wesentlichen zur Region, an der das mindestens eine Profilelement 200 am breitesten ist. Zwischen dieser Region und dem distalen Ende 202 weisen beide Kanten eine konvexe Form auf. Das distale Ende 202 ist spitz ausgebildet. Streng genommen hört die Konkavität schon vor Erreichen der breitesten Stelle auf, da der Krümmungswechsel vorher erfolgen muss. Wäre die Kontur an der breitesten Stelle noch konkav, würde sie sich nicht wieder schließen. Anders ausgedrückt soll die Geometrie derart verstanden werden, dass sich die Kontur konkav öffnet und nach einem Krümmungswechsel konvex wieder schließt.

Eine Gratlinie 208 ist entlang der ganzen Länge des mindestens einen Profilelements vorhanden, also zwischen dem proximalen Ende 204 und dem distalen Ende 202. Die Gratlinie 208 ist zwischen der ersten Profilfläche 210 und der zweiten Profilfläche 212. Aus der Fig. 8 kann insbesondere der Verlauf der Außenkontur der ersten Profilfläche 210 und der zweiten Profilfläche 212 gesehen werden. Wenn mehrere pfeilspitzenförmige Elemente nebeneinander als ein Profilelement 200 angeordnet sind, wie beispielsweise in Fig. 2, 3, 23, 24 gezeigt, dann überlappen die nebeneinander angeordneten pfeilspitzenförmigen Elemente, so dass Teile der individuellen Außenkontur nicht mehr sichtbar ist.

Fig. 9 zeigt eine schematische Ansicht eines pfeilspitzenförmigen Teils des mindestens einen Profilelements 200. Das mindestens eine Profilelement 200 ist in einer Seitenansicht, also einer Ansicht in Rotorblattlängsrichtung, gezeigt. Das Koordinatensystem unten rechts zeigt in Richtung der Länge L des mindestens einen Profilelements 200 und in Richtung der Dicke D des Profilelements 200 beziehungsweise entsprechend des Rotorblattes 108, wobei diese Richtungen orthogonal zueinander sind und sich in derselben Ebene befinden. In Fig. 9 ist eine mögliche geometrische Ausbildung des Dickenverlaufs des Profilelements 200 gezeigt. Beide, die saugseitige Profilseite 218 und die druckseitige Profilseite 226 sind am proximalen Ende 204, sowie am distalen Ende 202, spitz ausgebildet. Angefangen von dem proximale Ende 204 in Richtung des distalen Ende 202, weisen beide Kanten, welche hier in vertikaler Richtung den Rand des mindestens einen Profilelements 200 bilden, eine konvexe Form auf, bis zu der Region, an der das mindestens eine Profilelement 200 am dicksten ist. Zwischen dieser Region und dem distalen Ende 202 weisen beide Kanten eine konvexe Form auf. Der Befestigungsspalt 206 erstreckt sich vom proximalen Ende 204 bis zu einer Auskragebene 244, wobei die Auskragebene 244 die Ebene der Hinterkante des Rotorblattes beschreibt, hinter welcher das Profilelement 200 in Richtung distales Ende 202 auskragt.

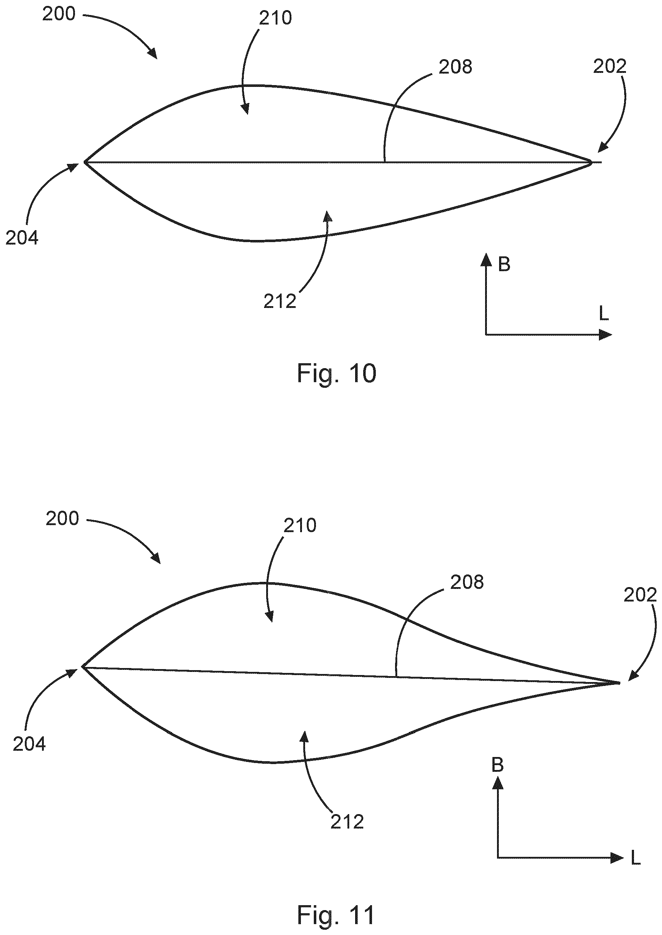

Die Fig. 10 bis 16 zeigen jeweils eine schematische Ansicht eines pfeilspitzenförmigen Teils des Profilelements 200. Das Profilelement 200 ist mit einer Draufsicht, also einer Ansicht von oben, gezeigt. Die Fig. 10 bis 16 zeigen die selbe Ansicht des mindestens einen Profilelements 200 wie Fig. 8, zeigen aber alternative Ausgestaltungen des mindestens einen Profilelements 200.

In Fig. 10 ist eine mögliche geometrische Ausbildung des mindestens einen Profilelements 200 in Richtung der Breite B und der Länge L des mindestens einen Profilelements 200 gezeigt. Das proximale Ende 204 ist spitz ausgebildet. Angefangen von dem proximale Ende 204 in Richtung des distalen Ende 202, weisen beide Kanten, welche hier in vertikaler Richtung den Rand des mindestens einen Profilelements 200 bilden, eine konvexe Form auf bis zur Region an der das mindestens einen Profilelements 200 am breitesten ist. Zwischen dieser Region und dem distalen Ende 202 weisen beide Kanten eine konvexe Form auf. Das distale Ende 202 ist spitz ausgebildet.

In Fig. 11 weisen, abweichend von Fig. 10, die Kanten, die die Außenkontur bilden, zwischen der breitesten Region und dem distalen Ende 202 eine konkave Form auf.

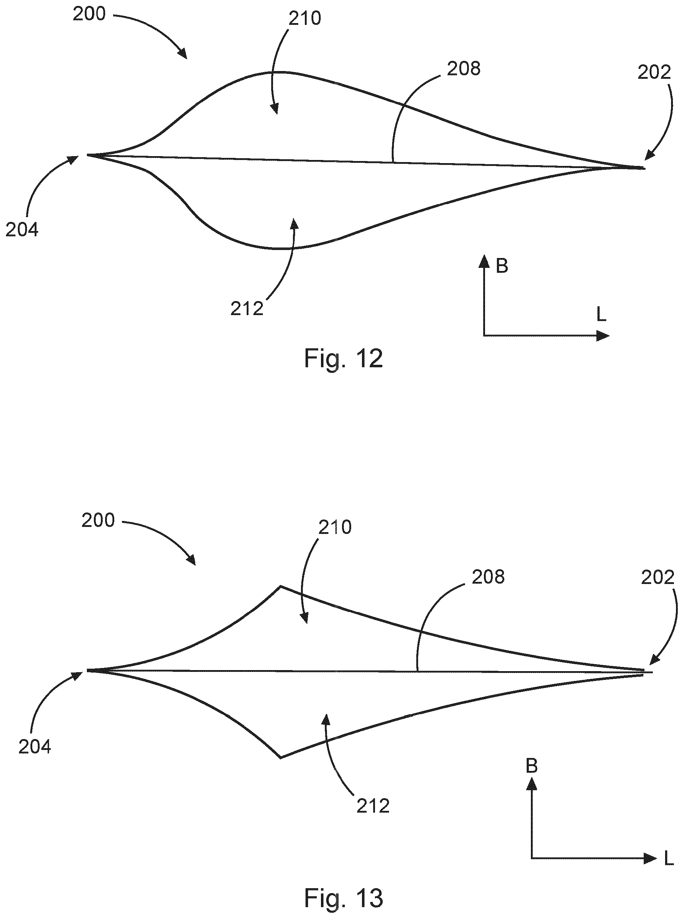

In Fig. 12 sind die Kanten, die die Außenkontur bilden, beiderseitig der breitesten Region konkav ausgebildet.

In Fig. 13 ist die Außenkontur in der breitesten Region nicht abgerundet, sondern spitz ausgebildet, diese Ausführung kann natürlich mit sämtlichen Verläufen der Fig. 10 bis 12 kombiniert werden.

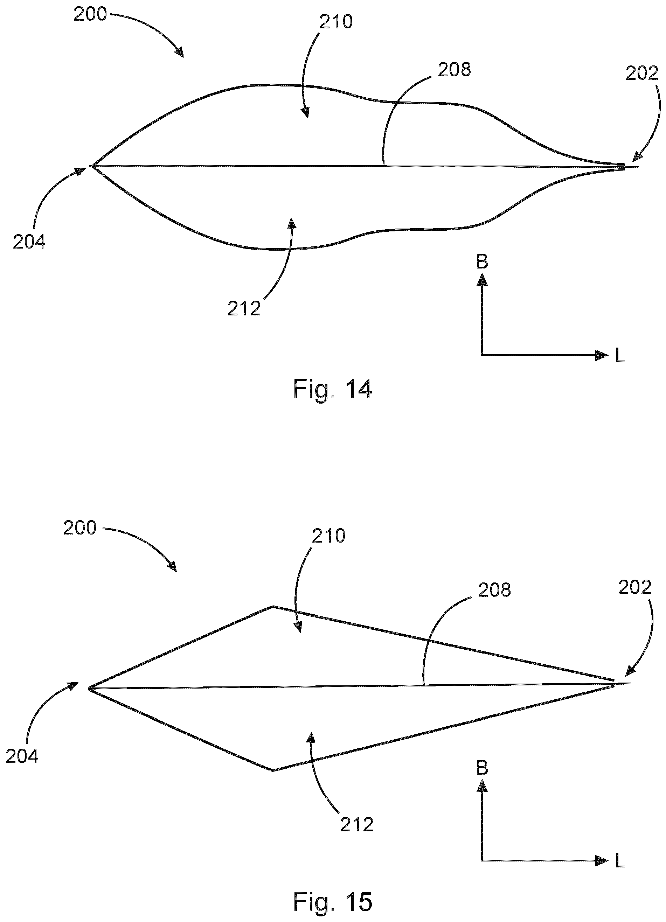

In Fig. 14 ist eine mögliche geometrische Ausbildung des mindestens einen Profilelements 200 in Richtung der Breite B und der Länge L des mindestens einen Profilelements 200 gezeigt. Das proximale Ende 204 ist spitz ausgebildet. Angefangen von dem proximalen Ende 204 in Richtung des distalen Endes 202, weisen beide Kanten, welche hier in vertikaler Richtung den Rand des mindestens einen Profilelements 200 bilden, in einer beliebigen Anzahl aufeinanderfolgender Bereiche, eine konvexe oder konkave Form auf. Hier sind exemplarisch, angefangen von dem proximalen Ende 204 in Richtung des distalen Ende 202, beide Kanten, welche hier in vertikaler Richtung den Rand des mindestens einen Profilelements 200 bilden, zuerst konvex, dann konkav, wieder konvex und sind danach bis zum distalen Ende 202 konkav ausgebildet.

In Fig. 15 ist eine mögliche geometrische Ausbildung mit abschnittsweise geraden Außenkonturen gezeigt.

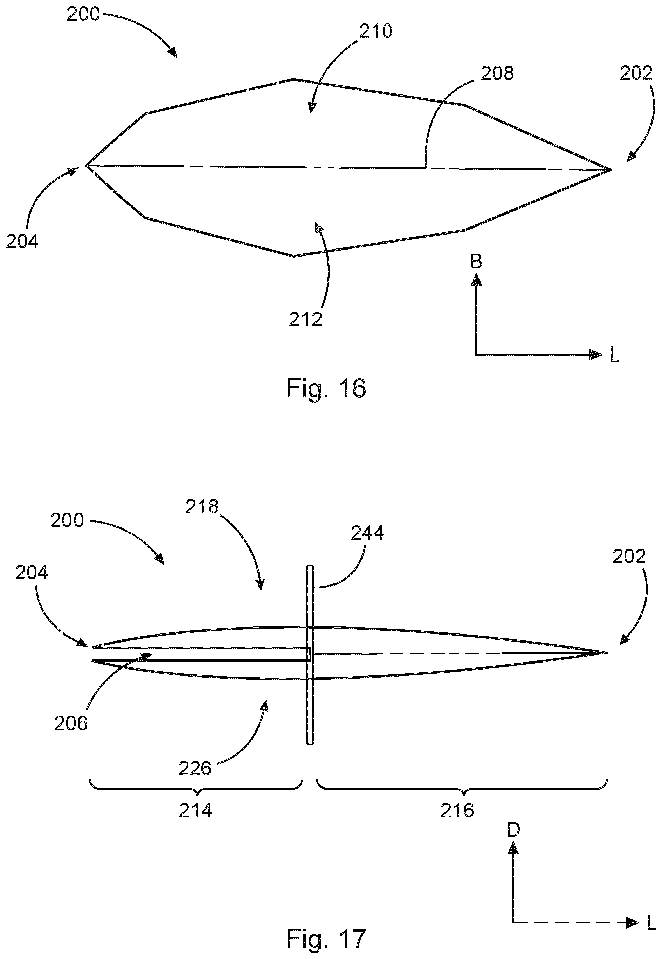

In Fig. 16 ist eine mögliche geometrische Ausbildung mit mehr als zwei abschnittsweise geraden Abschnitten der Außenkonturen gezeigt.

Die Fig. 17 bis 22 zeigen jeweils eine schematische Seitenansicht eines pfeilspitzenförmigen Teils des Profilelements 200 in derselben Ansicht des mindestens einen Profilelements 200 wie Fig. 9, zeigen aber alternative Ausgestaltungen des Profilelements 200, also insbesondere des Dickenverlaufs des Profilelements 200 über die Länge des Profilelements 200, wobei sich der Dickenverlauf sowohl durch den druckseitigen Konturverlauf als auch den saugseitigen Konturverlauf ausbildet.

In Fig. 17 weisen, ausgehend von dem proximalen Ende 204 in Richtung des distalen Endes 202, beide Kanten, welche hier in vertikaler Richtung den Rand des Profilelements 200 bilden, eine konvexe Form auf bis zur Region an der das Profilelement 200 am dicksten ist. Zwischen dieser Region und dem distalen Ende 202 weisen beide Kanten eine konvexe Form auf.

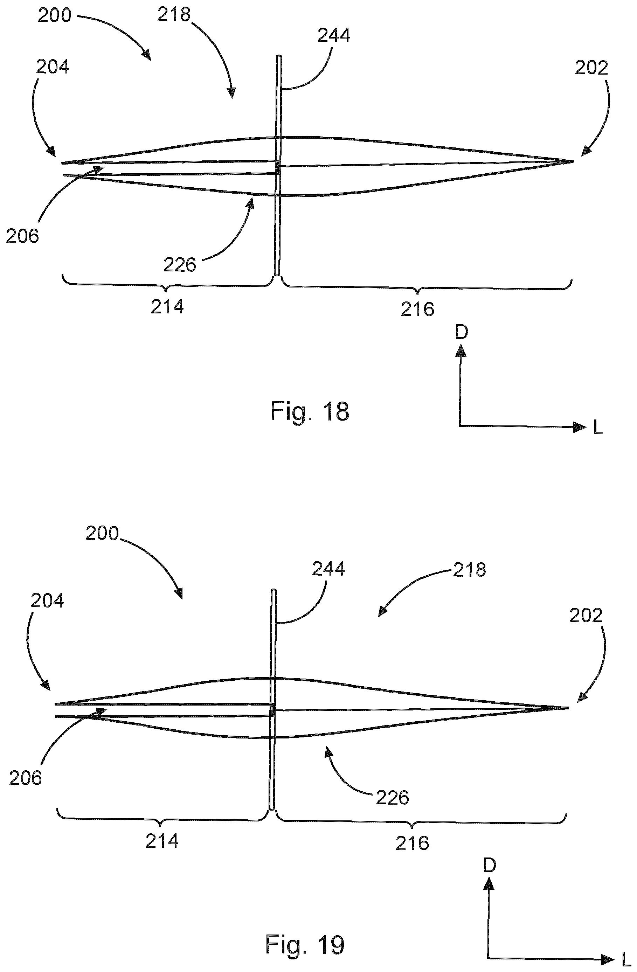

In Fig. 18 weisen beide Kanten eine konkave Form auf bis zur Region an der das Profilelement 200 am dicksten ist. Zwischen dieser Region und dem distalen Ende 202 weisen beide Kanten eine konvexe Form auf.

In Fig. 19 weisen beide Kanten eine konkave Form auf bis zur Region an der das mindestens eine Profilelement 200 am dicksten ist. In der Region, an der das mindestens eine Profilelement 200 am dicksten ist, weisen beide Kanten eine konvexe Form auf. Zwischen dieser Region und dem distalen Ende 202 weisen beide Kanten eine konkave Form auf.

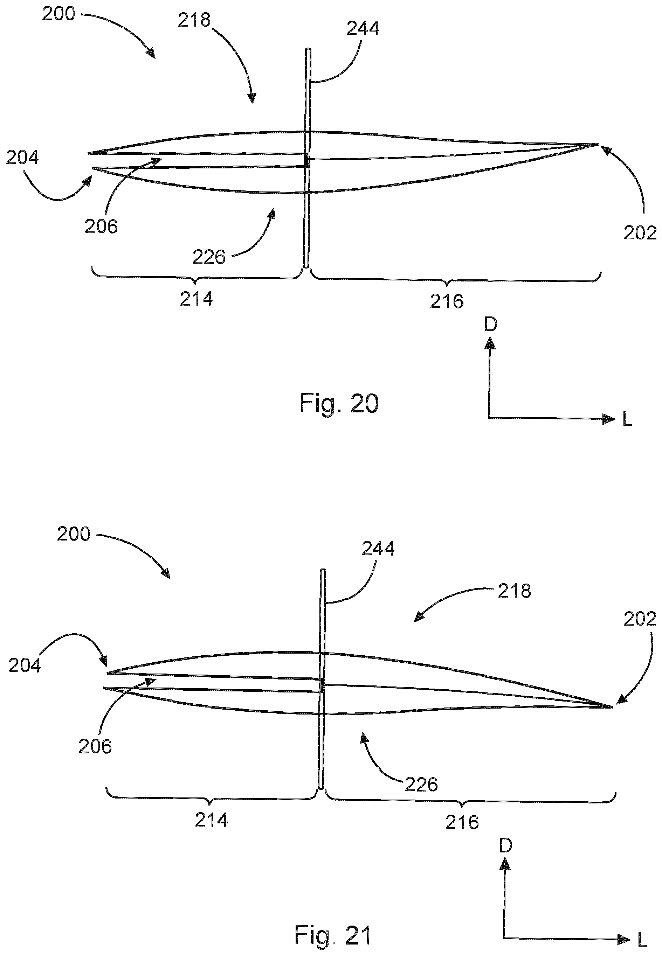

In Fig. 20 ist eine mögliche geometrische Ausbildung des mindestens einen Profilelements 200 in Richtung der Länge L und der Dicke D des mindestens einen Profilelements 200 gezeigt. Der Befestigungsspalt 206 erstreckt sich vom proximalen Ende 204 bis zu der Auskragebene 244. Nach der Auskragebene 244, in Richtung distalem Ende 202, weist der auskragende Teil des mindestens einen Profilelements 200 eine negative Wölbung auf, wobei mit negativer Wölbung, eine Wölbung in Richtung der saugseitigen Profilseite 218 gemeint ist.

In Fig. 21 weist abweichend von Fig. 20 der auskragende Teil des mindestens einen Profilelements 200 eine positive Wölbung auf, wobei mit positiver Wölbung, eine Wölbung in Richtung der druckseitigen Profilseite 226 gemeint ist.

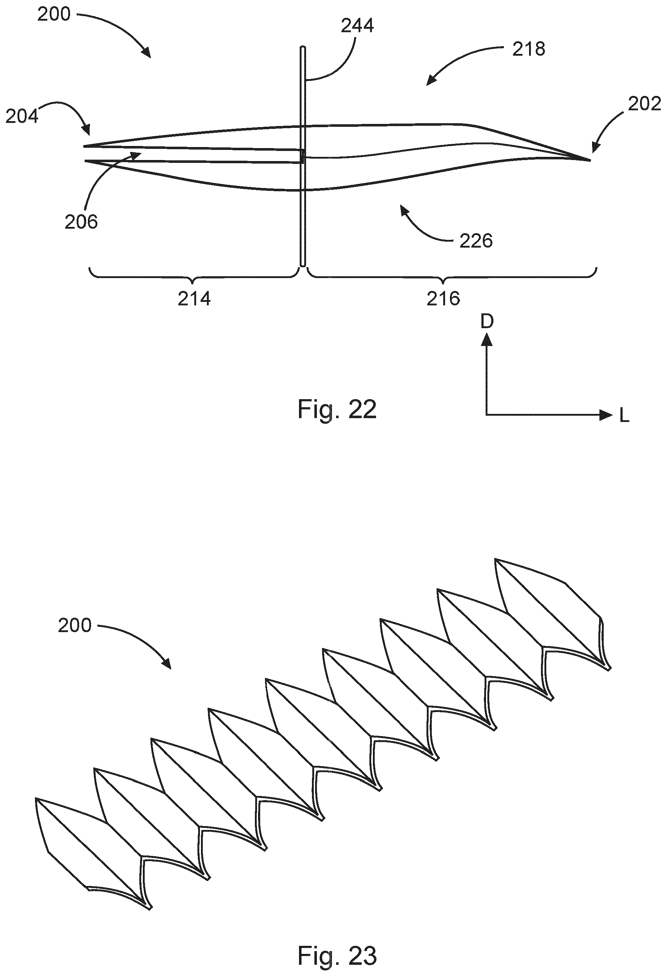

In Fig. 22 weist auskragende Teil des mindestens einen Profilelements 200 eine Kombination aus positiver und negativer Wölbung auf. Mit anderen Worten, weist der auskragende Teil des mindestens einen Profilelements 200 nach der Auskragebene 244, in Richtung distalem Ende 202, Abschnitte auf welche eine positive Wölbung offenbaren, sowie Abschnitte welche eine negative Wölbung offenbaren, auf.

Fig. 23 zeigt eine schematische, dreidimensionale Ansicht des Profilelements 200. Das mindestens eine Profilelement weist eine Vielzahl von Pfeilspitzenformen auf, wobei sich jede Pfeilspitzenform mit der oder den direkt benachbarten Pfeilspitzenformen überschneidet und die jeweiligen Überschnittstellen wie vertikal abgeschnitten und dann mit dieser Schnittstelle aneinandergeklebt sind. Hier erstrecken sich die Überschnittstellen auf ungefähr ein Drittel der Distanz zwischen dem proximalen Ende und dem distalen Ende der jeweiligen Pfeilspitzenformen die sich überschneiden. In der hier gezeigten Ausführung haben alle Pfeilspitzenformen des mindestens einen Profilelements 200 dieselbe Länge, wobei die Länge als die Distanz zwischen dem proximalen Ende und dem distalen Ende der jeweiligen Pfeilspitzenformen zu verstehen ist. Auch die Überschnittstellen haben in der hier gezeigten Ausführung alle die gleiche Länge.

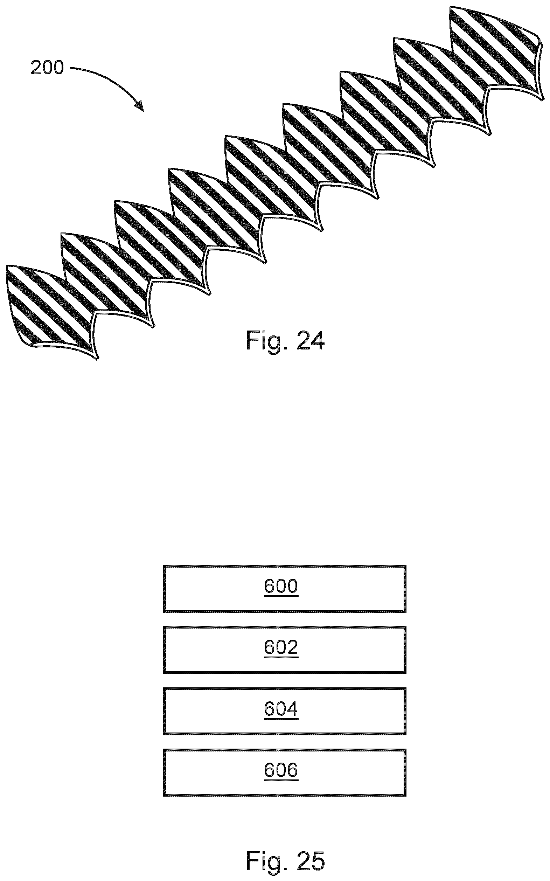

Fig. 24 zeigt eine schematische, dreidimensionale Ansicht des Profilelements 200. Das mindestens eine Profilelement weist eine Vielzahl von Pfeilspitzenformen auf, wobei sich jede Pfeilspitzenform mit der oder den direkt benachbarten Pfeilspitzenformen überschneidet und die jeweiligen Überschnittstellen wie vertikal abgeschnitten und dann mit dieser Schnittstelle aneinandergeklebt sind. In der hier gezeigten Ausführung weisen alle Pfeilspitzenformen des mindestens einen Profilelements 200 mehrere Rillen und mehrere Gratlinien auf, wie es beispielsweise in Fig. 5 zu sehen ist. In Fig. 24 sind demnach mehrere der Profilelemente 200, die in Fig. 5 gezeigt sind, nebeneinander angeordnet.

Fig. 25 zeigt ein schematisches Verfahren. In Schritt 600 wird mindestens ein Profilelement 200 mit einem Querschnitt, der mindestens ein lokales Minimum der Profilelementdicke aufweist, bereitgestellt. In Schritt 602 wird das mindestens eine Profilelement 200 an einer Hinterkante 114 eines Rotorblatts 108 angeordnet. In Schritt 604 wird das mindestens eine Profilelement 200 an der Hinterkante 114 derart angeordnet, dass ein Abschnitt der Hinterkante 114 innerhalb des Befestigungsspalts 206 angeordnet ist. In Schritt 606 wird das mindestens eine Profilelement 200 mit einem an die Hinterkante 114 angrenzenden Hinterkantenbereich 116 verklebt.

Die vorliegende Erfindung verbessert bisher eingesetzte Trailing Edge Serrations (TES) und kombiniert diese mit den Vorteilen von sogenannten Finlets, bei denen es sich um kleine an der Hinterkante angebrachte, vertikal zur Blattoberfläche ausgerichtete Flügelchen handelt, die spannweitige Druckfluktuationen dämpfen. Hierdurch sind Profilelemente 200 entwickelt worden, die sich von bisherigen TES unterscheiden. Die neuen Profilelemente 200 werden aufgrund ihres Aussehens auch als Kalmar-TES bezeichnet und vereinigen die Konzepte von Finlets und TES zu einem Bauteil.

Die Kalmar-TES bzw. die Profilelemente 200 sind dreidimensionelle Bauteile. In einer ersten Variante weist jeder einzelne Zahn einen in Längsrichtung verlaufenden scharfen Grat auf, der von der Mittellinie zur Seite abfällt und seitlich tangentenstetig in die Blattoberfläche übergeht. Zum sicheren Verkleben der Kalmar-TES wird das Profilelement bis zur Auskragebene 244 aufgeschoben.

Damit es im Betrieb des Rotorblattes 108 nicht zu Strömungsablösungen durch Vorstaueffekte an der Vorderkante des Profilelements 200 kommt, steigt auch hier vorzugsweise die Oberfläche tangentenstetig mit kleinem Winkel zum Grat an. Das bedeutet, die Stirnfläche der nach vorne zeigenden Anlaufkante ist annähernd null. Werden mehrere Kalmar-TES, wie beispielsweise in Fig. 23 oder 24 gezeigt, spannweitig angeordnet, ergibt sich ein symmetrisches Muster aus einem Grat und einem Tal. Durch diese strukturierte Anordnung der Profilelemente 200 werden die turbulenten Strukturen in der Grenzschicht, insbesondere die spannweitigen Komponenten, aufgebrochen. Die aufgebrochenen Strukturen können dann als kleinere Strukturen über die TES abschwimmen.

Darüber hinaus wird auch erwartet, dass durch die dreidimensionale Struktur der Kalmar-TES, also der Profilelemente 200, die Richtcharakteristik der dominanten Schallquellen insofern verändert wird, als dass die Schallquelle diffuser abstrahlt und idealerweise weniger Lärm an der für die Schallleistungsvermessung vorgeschriebenen Messposition der Windenergieanlage 100 ankommt.

An dieser Messposition tritt bisher, bedingt durch die dipol-ähnliche Abstrahlcharakteristik des Hinterkantenlärms, üblicherweise ein Maximum des Schalleistungspegels auf. Die Breite der Kalmar-TES bestimmt, welche Längenskalen besonders beeinflusst werden. Außerdem kann auch das Länge-/Breite-Verhältnis der TES optimiert werden.

Wird wie in Fig. 24 bzw. Fig. 7 gezeigt das Profilelement 200 weiter modifiziert, indem man auf Kalmar-TES mehrere Rillen (mehrere Grate und Täler) aufbringt. (s. Abb. 3), kann gezielt auf eine noch kleinere "Wellenlänge" der dreidimensionalen Struktur ausgelegt werden. Die Tiefe und Breite der Rillen und der Winkel zum Grat kann variiert und optimiert werden, um die gewünschten Längenskalen in der turbulenten Grenzschicht besonders vorteilhaft zu beeinflussen. Werden die TES Profilelemente 200, vgl. Fig. 24, spannweitig angeordnet, bleibt die zu beeinflussende Längenskala gleich. Je nach Variante werden eher groß-skalige oder klein-skalige Turbulenzstrukturen verändert, wodurch sich dann auch der Effekt der Kalmar-TES in verschiedenen Frequenzbändern niederschlagen wird. Eine gezielte Auslegung auf den dominanten Frequenzbereich des Hinterkantenlärms ist auf diese Weise möglich.

Dadurch, dass die Profilelemente 200 nur über die Hinterkante geschoben und aufgeklebt wird die Integration günstiger und eignet sich hervorragend als Nachrüstlösung. Außerdem ergeben sich auch Vorteile in der Lebensdauer des Bauteils, da die Profilelemente 200 von beiden Seiten an das Profil geklebt werden können und so gegen Abschälen gesichert ist. Für eine noch bessere Verklebung, kann die Kalmar-TES auch aus zwei Halbschalen bestehen, separat druck- und saugseitig verklebt werden.

### BEZUGSZEICHEN

- 100: Windenergieanlage
- 102: Turm
- 104: Gondel
- 106: Rotor
- 108: Rotorblätter
- 110: Spinner
- 112: Vorderkante
- 114: Hinterkante
- 116: Hinterkantenbereich
- 118: Saugseite
- 120: Druckseite
- 122: Auskragrichtung
- 200: Profilelement
- 202: distales Ende
- 204: proximales Ende
- 206: Befestigungsspalt
- 208: Gratlinie
- 210: erste Profilfläche
- 212: zweite Profilfläche
- 214: proximaler Abschnitt
- 216: distaler Abschnitt
- 218: saugseitige Profilseite
- 220: erste Profilfläche
- 222: zweite Profilfläche
- 224: Gratlinie bzw. Gratkante
- 226: druckseitige Profilseite
- 228: Rille
- 230: Rille
- 232: Rille
- 234: Rille
- 236: Rille
- 238: Rille
- 240: Rille
- 242: Rille
- 244: Auskragebene
- 246: erste Profileinheit
- 248: zweite Profileinheit

## Patentansprüche

1. Rotorblatt (108) einer Windenergieanlage (100), wobei das Rotorblatt eine Vorderkante (112), eine Hinterkante (114), eine Saugseite (118) und eine Druckseite (120) aufweist und sich in einer Rotorblattlängsrichtung zwischen einem Wurzelende und einem Spitzenende erstreckt,
wobei eine direkte Verbindung zwischen der Vorderkante (112) und der Hinterkante (114) als Profilsehne bezeichnet wird und deren Länge als Profiltiefe bezeichnet wird,
wobei das Rotorblatt (108) mindestens ein Profilelement (200) aufweist, wobei das mindestens eine Profilelement (200) mit einem proximalen Abschnitt (214) an einem Hinterkantenbereich (116) angrenzend an die Hinterkante (114) angeordnet ist und mit einem distalen Abschnitt (216) von der Hinterkante (114) mit einer Auskragrichtung (122), welche im Wesentlichen parallel zur Richtung der Profiltiefe ausgerichtet ist, auskragt,
wobei das mindestens eine Profilelement (200) eine Profilelementdicke in einer Richtung senkrecht zur Auskragrichtung (122) aufweist,
wobei das mindestens eine Profilelement (200) eine der Druckseite (120) zugeordnete, druckseitige Profilseite (226) und eine der Saugseite (118) zugeordnete, saugseitige Profilseite (218) aufweist,
wobei das mindestens eine Profilelement (200) im Wesentlichen orthogonal zu der Auskragrichtung (122) einen Querschnitt aufweist,
wobei
der Querschnitt des mindestens einen Profilelements (200) mindestens ein lokales Minimum der Profilelementdicke aufweist, wobei die Profilelementdicke in dem Querschnitt beiderseitig des lokalen Minimums einen größeren Wert aufweist,
der proximale Abschnitt (214) und der distale Abschnitt (216) des mindestens einen Profilelements (200) pfeilspitzenförmig ausgebildet sind und das proximale Ende (204) und das distale Ende (202) jeweils im Wesentlichen rund oder spitz ausgebildet sind, beispielsweise das proximale Ende (204) spitz und das distale Ende (202) rund, **dadurch gekennzeichnet, dass** die druckseitige Profilseite (226) des mindestens einen Profilelements (200) eine Spiegelung, in Bezug auf die Ebene welche von der Hinterkante (114) und der Auskragrichtung (122) aufgespannt wird, der saugseitigen Profilseite (218) ist.

2. Rotorblatt (108) nach Anspruch 1, wobei das mindestens eine Profilelement (200) mehrere Querschnitte an unterschiedlichen Positionen, in einer Richtung parallel zur Auskragrichtung (122), aufweist, wobei jeder der mehreren Querschnitte jeweils mindestens ein lokales Minimum der Profilelementdicke aufweist, die auf einer Linie liegen, wobei die Verbindung aller lokalen Minima, die auf einer Linie liegen, als Rille (230) bezeichnet wird, und
wobei jeder der mehreren Querschnitte jeweils mindestens ein lokales Maximum der Profilelementdicke aufweist, die auf einer Linie liegen, wobei die Verbindung aller lokalen Maxima, die auf einer Linie liegen, als Gratlinie (208) bezeichnet wird.

3. Rotorblatt (108) nach Anspruch 2, wobei das mindestens eine Profilelement (200), für jede Rille (230)
- eine Profilfläche, welche sich auf der Rotorblattwurzelseite der jeweiligen Rille (230) befindet und sich zwischen der jeweiligen Rille (230) und der Gratlinie (208), welche sich auf derselben Profilseite direkt auf der Rotorblattwurzelseite der jeweiligen Rille (230) befindet, erstreckt, wobei die Profilfläche eine in Richtung der Rotorblattspitzenseite abnehmende Profilelementdicke aufweist, und
- eine Profilfläche, welche sich auf der Rotorblattspitzenseite der jeweiligen Rille (230) befindet und sich zwischen der jeweiligen Rille (230) und der Gratlinie (208), welche sich auf derselben Profilseite direkt auf der Rotorblattspitzenseite der jeweiligen Rille (230) befindet, erstreckt, wobei die Profilfläche eine in Richtung der Rotorblattspitzenseite zunehmende Profilelementdicke aufweist,
wobei jede Profilfläche konvex, konkav oder gerade ausgebildet ist.

4. Rotorblatt (108) nach einem der Ansprüche 2 bis 3, wobei das mindestens eine Profilelement (200) auf der druckseitigen Profilseite (226) und/oder auf der saugseitigen Profilseite (218), angefangen von einer Rotorblattwurzelseite, eine erste Profilfläche aufweist, wobei die erste Profilfläche eine in Richtung der Rotorblattspitzenseite zunehmende Profilelementdicke aufweist und wobei die erste Profilfläche ihre maximale Profilelementdicke entlang einer ersten Gratlinie (208), welche parallel zur Profilsehne verläuft, erreicht,
wobei jede Profilfläche konvex, konkav oder gerade ausgebildet ist.

5. Rotorblatt (108) nach einem der Ansprüche 2 bis 4, wobei das mindestens eine Profilelement (200) auf der druckseitigen Profilseite (226) und/oder auf der saugseitigen Profilseite (218), angefangen von einer Rotorblattwurzelseite, auf der Rotorblattspitzenseite der letzten Gratlinie (208), in Richtung der Rotorblattspitzenseite, eine letzte Profilfläche aufweist, wobei die letzte Profilfläche eine in Richtung des Rotorblattspitzenendes abnehmende Profilelementdicke aufweist und wobei die letzte Profilfläche ihre minimale Profilelementdicke entlang dem Rand des mindestens einen Profilelements (200) erreicht,
wobei jede Profilfläche konvex, konkav oder gerade ausgebildet ist.

6. Rotorblatt (108) nach einem der Ansprüche 3 bis 5, wobei sich jede Profilfläche des mindestens einen Profilelements (200) von einem distalen Ende (202) hin zu einem proximalen Ende (204) des mindestens einen Profilelements (200) erstreckt.

7. Rotorblatt (108) nach einem der Ansprüche 3 bis 6, wobei jede Profilfläche des mindestens einen Profilelements (200) welche an eine Rille (230) angrenzend ist im Wesentlichen kongruent zu der zweiten Profilfläche, welche an dieselbe Rille (230) angrenzend ist, ausgebildet ist.

8. Rotorblatt (108) nach einem der Ansprüche 2 bis 7, wobei mindestens eine Gratlinie (208) des mindestens einen Profilelements (200) eine scharfe Kante aufweist.

9. Rotorblatt (108) nach einem der Ansprüche 2 bis 8, wobei mindestens eine Rille (230) des mindestens einen Profilelements (200) eine scharfe Kante aufweist.

10. Rotorblatt (108) nach einem der Ansprüche 2 bis 9, wobei jede Gratlinie (208, 224) und jede Rille (230) der druckseitigen Profilseite (226) des mindestens einen Profilelements (200) in jedem Punkt senkrecht, in Bezug auf die Auskragrichtung (122), unter einer jeweiligen Gratlinie und einer jeweiligen Rille (230) der saugseitigen Profilseite (218) des mindestens einen Profilelements (200) angeordnet ist.

11. Rotorblatt (108) nach einem der vorherigen Ansprüche, wobei der proximale Abschnitt (214) und der distale Abschnitt (216) des mindestens einen Profilelements (200) aus mehreren parallel angeordneten Pfeilspitzenformen, wobei sich jede Pfeilspitzenform mit der oder den direkt benachbarten Pfeilspitzenformen überschneidet, ausgebildet sind und wobei für jede Pfeilspitzenform das proximale Ende (204) und das distale Ende (202) jeweils im Wesentlichen rund oder spitz ausgebildet sind.

12. Rotorblatt (108) nach einem der vorherigen Ansprüche, wobei zwischen der druckseitigen Profilseite (226) und der saugseitigen Profilseite (218) im proximalen Abschnitt (214) ein Befestigungsspalt (206) ausgebildet ist, wobei der Hinterkantenbereich (116) zumindest teilweise innerhalb des Befestigungsspalts (206) angeordnet ist.

13. Rotorblatt (108) nach einem der vorherigen Ansprüche, wobei das mindestens eine Profilelement (200) zweiteilig ausgebildet ist, wobei ein erster Teil die druckseitige Profilseite (226) und ein zweiter Teil die saugseitige Profilseite (218) aufweist, wobei der erste Teil an der Druckseite (120) und der zweite Teil an der Saugseite (118) befestigt ist, vorzugsweise durch Kleben, wobei vorzugsweise die von der Hinterkante (114) auskragenden Abschnitte des ersten Teils und des zweiten Teils miteinander befestigt, vorzugsweise verklebt, sind.

14. Rotorblatt (108) nach einem der vorherigen Ansprüche, wobei sich zwischen der druckseitigen Profilseite (226) und der saugseitigen Profilseite (218) des mindestens einen Profilelements (200) eine Elementdicke (D) einstellt, und die Elementdicke von dem proximalen Ende (204) hin zu einer maximalen Elementdicke an einer Profilelementstelle ansteigt und die Elementdicke von dieser Profilelementstelle hin zum distalen Ende (202) hin abnimmt.

15. Rotorblatt (108) nach einem der vorherigen Ansprüche, umfassend zwei oder mehr Profilelemente (200), die entlang der Hinterkante (114) benachbart zueinander angeordnet sind und aneinanderstoßen.

16. Windenergieanlage (100) mit einem Rotorblatt (108) nach einem der vorstehenden Ansprüche.

17. Windpark mit mehreren Windenergieanlagen (100) nach Anspruch 16.

18. Verfahren zur Optimierung eines Rotorblatts (108), wobei das Rotorblatt (108) eine Vorderkante (112), eine Hinterkante (114), eine Saugseite (118) und eine Druckseite (120) aufweist und sich in einer Rotorblattlängsrichtung zwischen einem Wurzelende und einem Spitzenende erstreckt,
wobei eine direkte Verbindung zwischen der Vorderkante (112) und der Hinterkante (114) als Profilsehne bezeichnet wird und deren Länge als Profiltiefe bezeichnet wird, umfassend:
- Montieren von mindestens einem Profilelement (200), wobei das mindestens eine Profilelement (200) mit einem proximalen Abschnitt (214) an einem Hinterkantenbereich (116) angrenzend an die Hinterkante (114) angeordnet ist und mit einem distalen Abschnitt (216) von der Hinterkante (114) mit einer Auskragrichtung (122), welche im Wesentlichen parallel zur Richtung der Profiltiefe ausgerichtet ist, auskragt,
wobei das mindestens eine Profilelement (200) eine Profilelementdicke in einer Richtung senkrecht zur Auskragrichtung (122) zwischen einer Ebene, welche von der Hinterkante (114) und der Auskragrichtung (122) aufgespannt wird, und der Oberfläche des mindestens einen Profilelements (200) aufweist,
wobei das mindestens eine Profilelement (200) eine der Druckseite (120) zugeordnete, druckseitige Profilseite (226) und eine der Saugseite (118) zugeordnete, saugseitige Profilseite (218) aufweist,
wobei das mindestens eine Profilelement (200) im Wesentlichen orthogonal zu der Auskragrichtung (122) einen Querschnitt aufweist,
wobei
der Querschnitt des mindestens einen Profilelements (200) mindestens ein lokales Minimum der Profilelementdicke aufweist, wobei die Profilelementdicke in dem Querschnitt beiderseitig des lokalen Minimums einen größeren Wert aufweist,
der proximale Abschnitt (214) und der distale Abschnitt (216) des mindestens einen Profilelements (200) pfeilspitzenförmig ausgebildet sind und das proximale Ende (204) und das distale Ende (202) jeweils im Wesentlichen rund oder spitz ausgebildet sind, beispielsweise das proximale Ende (204) spitz und das distale Ende (202) rund, **dadurch gekennzeichnet, dass** die druckseitige Profilseite (226) des mindestens einen Profilelements (200) eine Spiegelung, in Bezug auf die Ebene welche von der Hinterkante (114) und der Auskragrichtung (122) aufgespannt wird, der saugseitigen Profilseite (218) ist.

## Claims

1. A rotor blade (108) of a wind turbine (100), wherein the rotor blade has a leading edge (112), a trailing edge (114), a suction surface (118) and a pressure surface (120), and extends in a longitudinal direction of a rotor blade between a root end and a tip end,
wherein a direct connection between the leading edge (112) and the trailing edge (114) is termed the chord line and the length thereof is termed the chord length,
wherein the rotor blade (108) has at least one airfoil element (200), wherein the at least one airfoil element (200) is arranged at the trailing edge (114) with a proximal portion (214) adjoining a trailing edge region (116) and projects from the trailing edge (114) with a distal portion (216) having a projecting direction (122), which is oriented substantially parallel to the direction of the chord length,
wherein the at least one airfoil element (200) has an airfoil element thickness in a direction perpendicular to the projecting direction (122),
wherein the at least one airfoil element (200) has a pressure-surface airfoil side (226) facing the pressure surface (120) and a suction-surface airfoil side (218) facing the suction surface (118),
wherein the at least one airfoil element (200) has a cross-section substantially orthogonal to the projecting direction (122),
wherein the cross-section of the at least one airfoil element (200) has at least one local minimum of the airfoil element thickness, wherein the airfoil element thickness in the cross-section on both sides of the local minimum has a larger value
the proximal portion (214) and the distal portion (216) of the at least one airfoil element (200) are formed in the shape of arrowheads, and wherein the proximal end (204) and the distal end (202) each are formed substantially round or pointed; for example, the proximal end (204) may be pointed and the distal end (202) may be round
**characterized in that** the pressure-surface airfoil side (226) of the at least one airfoil element (200) is a reflection of the suction-surface airfoil side (218) with respect to the plane spanned by the trailing edge (114) and the projecting direction (122).

2. The rotor blade (108) according to claim 1, wherein the at least one airfoil element (200) has multiple cross-sections at different positions in a direction parallel to the projecting direction (122), wherein each of the multiple cross-sections has at least one respective local minimum of the airfoil element thickness on a common line, wherein the connection of all local minimums on a common line is termed a groove (230), and
wherein each of the multiple cross-sections has at least one respective local maximum of the airfoil element thickness on a common line, wherein the connection of all local maximums on a common line is termed a ridge line (208).

3. The rotor blade (108) according to claim 2, wherein the at least one airfoil element (200) has, for each groove (230),
- an airfoil surface located on the rotor blade root side of the individual grooves (230) and extending between the respective groove (230) and the ridge line (208), which is located on the same airfoil side directly on the rotor blade root side of the individual groove (230), wherein the airfoil surface has an airfoil element thickness decreasing in the direction of the rotor blade tip side, and
- an airfoil surface located on the rotor blade tip side of the individual grooves (230) and extending between the respective groove (230) and the ridge line (208), which is located on the same airfoil side directly on the rotor blade tip side of the individual groove (230), wherein the airfoil surface has an airfoil element thickness increasing in the direction of the rotor blade tip side,
wherein each airfoil surface is formed convex, concave or straight.

4. The rotor blade (108) according to any one of claims 2 to 3, wherein the at least one airfoil element (200) has a first airfoil surface on the pressure-surface airfoil side (226) and/or on the suction-surface airfoil side (218), starting from a rotor blade root side, wherein the first airfoil surface has an airfoil element thickness increasing in the direction of the rotor blade tip side, and wherein the first airfoil surface reaches its maximum airfoil element thickness along a first ridge line (208), which extends parallel to the chord line,
wherein each airfoil surface is formed convex, concave or straight.

5. The rotor blade (108) according to any one of claims 2 to 4, wherein the at least one airfoil element (200) has a final airfoil surface on the pressure-surface airfoil side (226) and/or on the suction-surface airfoil side (218), starting from a rotor blade root side, on the rotor blade tip side of the final ridge line (208), in the direction of the rotor blade tip side, wherein the final airfoil surface has an airfoil element thickness decreasing in the direction of the rotor blade tip side, and wherein final last airfoil surface reaches its minimum airfoil element thickness along the edge of the at least one airfoil element (200),
wherein each airfoil surface is formed convex, concave or straight.

6. The rotor blade (108) according to any one of claims 3 to 5, wherein each airfoil surface of the at least one airfoil element (200) extends from a distal end (202) towards a proximal end (204) of the at least one airfoil element (200).

7. The rotor blade (108) according to any one of claims 3 to 6, wherein each airfoil surface of the at least one airfoil element (200) adjoining a groove (230) is formed substantially congruent with the second airfoil surface adjoining the same groove (230).

8. The rotor blade (108) according to any one of claims 2 to 7, wherein at least one ridge line (208) of the at least one airfoil element (200) has a sharp edge.

9. The rotor blade (108) according to any one of claims 2 to 8, wherein at least one groove (230) of the at least one airfoil element (200) has a sharp edge.

10. The rotor blade (108) according to any one of claims 2 to 9, wherein each ridge line (208, 224) and each groove (230) of the pressure-surface airfoil side (226) of the at least one airfoil element (200) is arranged perpendicularly with respect to the projecting direction (122) in each point, below a respective ridge line and a respective groove (230) of the suction-surface airfoil side (218) of the at least one airfoil element (200).

11. The rotor blade (108) according to any one of the preceding claims, wherein the proximal portion (214) and the distal portion (216) of the at least one airfoil element (200) are formed from multiple arrowhead shapes arranged parallel to one another, wherein each arrowhead shape overlaps the directly adjacent arrowhead shape(s), and wherein for each arrowhead shape the proximal end (204) and the distal end (202) each are formed substantially round or pointed.

12. The rotor blade (108) according to any one of the preceding claims, wherein a mounting gap (206) is formed between the pressure-surface airfoil side (226) and the suction-surface airfoil side (218) in the proximal portion (214), wherein the trailing edge region (116) is at least partially arranged inside the mounting gap (206).

13. The rotor blade (108) according to any one of the preceding claims, wherein the at least one airfoil element (200) is formed as two parts, wherein a first part has the pressure-surface airfoil side (226) and a second part has the suction-surface airfoil side (218), wherein the first part is attached to the pressure surface (120) and the second part is attached to the suction surface (118), preferably by gluing, wherein preferably the portions of the first part and the second part projecting from the trailing edge (114) are attached together, preferably glued.

14. The rotor blade (108) according to any one of the preceding claims, wherein an element thickness (D) forms between the pressure-surface airfoil side (226) and the suction-surface airfoil side (218) of the at least one airfoil element (200), and the element thickness increases from the proximal end (204) towards a maximum element thickness at an airfoil element position and the element thickness decreases from this airfoil element position towards the distal end (202).

15. The rotor blade (108) according to any one of the preceding claims, comprising two or more airfoil elements (200) that are arranged adjacent to one another along the trailing edges (114) and abut against one another.

16. A wind turbine (100) having a rotor blade (108) according to any one of the preceding claims.

17. A wind farm having multiple wind turbines (100) according to claim 16.

18. A method for optimizing a rotor blade (108), wherein the rotor blade (108) has a leading edge (112), a trailing edge (114), a suction surface (118) and a pressure surface (120), and extends in a longitudinal direction of a rotor blade between a root end and a tip end,
wherein a direct connection between the leading edge (112) and the trailing edge (114) is termed the chord line and the length thereof is termed the chord length, comprising:
- assembling at least one airfoil element (200), wherein the at least one airfoil element (200) is arranged at the trailing edge (114) with a proximal portion (214) adjoining a trailing edge region (116) and projects from the trailing edge (114) with a distal portion (216) having a projecting direction (122), which is oriented substantially parallel to the direction of the chord length,
wherein the at least one airfoil element (200) has an airfoil element thickness in a direction perpendicular to the projecting direction (122) between a plane spanned by the trailing edge (114) and the projecting direction (122) and the surface of the at least one airfoil element (200),
wherein the at least one airfoil element (200) has a pressure-surface airfoil side (226) facing the pressure surface (120) and a suction-surface airfoil side (218) facing the suction surface (118),
wherein the at least one airfoil element (200) has a cross-section substantially orthogonal to the projecting direction (122),
wherein the cross-section of the at least one airfoil element (200) has at least one local minimum of the airfoil element thickness, wherein the airfoil element thickness in the cross-section on both sides of the local minimum has a larger value,
the proximal portion (214) and the distal portion (216) of the at least one airfoil element (200) are formed in the shape of arrowheads, and wherein the proximal end (204) and the distal end (202) each are formed substantially round or pointed; for example, the proximal end (204) may be pointed and the distal end (202) may be round,
**characterized in that** the pressure-surface airfoil side (226) of the at least one airfoil element (200) is a reflection of the suction-surface airfoil side (218) with respect to the plane spanned by the trailing edge (114) and the projecting direction (122).

## Revendications

1. Pale de rotor (108) d'une éolienne (100), dans laquelle la pale de rotor présente un bord d'attaque (112), un bord de fuite (114), un côté aspiration (118) et un côté pression (120) et s'étend dans une direction longitudinale de pale de rotor entre une extrémité de racine et une extrémité de pointe,
dans laquelle une liaison directe entre le bord d'attaque (112) et le bord de fuite (114) est appelée corde de profil et dont la longueur est appelée profondeur de profil,
dans laquelle la pale de rotor (108) présente au moins un élément profilé (200), dans laquelle l'au moins un élément profilé (200) est disposé avec une section proximale (214) sur une zone de bord de fuite (116) de manière adjacente au bord de fuite (114) et est en porte-à-faux par une section distale (216) par rapport au bord de fuite (114) avec une direction de porte-à-faux (122) qui est sensiblement parallèle à la direction de la profondeur de profil,
dans laquelle l'au moins un élément profilé (200) présente une épaisseur d'élément profilé dans une direction perpendiculaire à la direction de porte-à-faux (122),
dans laquelle l'au moins un élément profilé (200) présente un côté profilé côté pression (226) associé au côté pression (120) et un côté profilé côté aspiration (218) associé au côté aspiration (118),
dans laquelle l'au moins un élément profilé (200) présente une section transversale de manière sensiblement orthogonale par rapport à la direction de porte-à-faux (122),
dans laquelle
la section transversale de l'au moins un élément profilé (200) présente au moins un minimum local de l'épaisseur d'élément profilé, dans laquelle l'épaisseur d'élément profilé présente, dans la section transversale de part et d'autre du minimum local, une valeur plus grande,
la section proximale (214) et la section distale (216) de l'au moins un élément profilé (200) sont réalisées en forme de pointe de flèche, et l'extrémité proximale (204) et l'extrémité distale (202) sont respectivement réalisées de manière sensiblement ronde ou pointue, par exemple, l'extrémité proximale (204) est pointue et l'extrémité distale (202) est ronde, **caractérisée en ce que** le côté profilé côté pression (226) de l'au moins un élément profilé (200) est une réflexion, par rapport au plan qui est formé par le bord de fuite (114) et la direction de porte-à-faux (122), du côté profilé côté aspiration (218).

2. Pale de rotor (108) selon la revendication 1, dans laquelle l'au moins un élément profilé (200) présente plusieurs sections transversales sur différentes positions, dans une direction parallèle à la direction de porte-à-faux (122), dans laquelle chacune des plusieurs sections transversales présente respectivement au moins un minimum local de l'épaisseur d'élément profilé, qui se situe sur une ligne, dans laquelle la liaison de tous les minima locaux, qui se situent sur une ligne, est appelée rainure (230), et
dans laquelle chacune des plusieurs sections transversales présente respectivement au moins un maximum local de l'épaisseur d'élément profilé, qui se situent sur une ligne, dans laquelle la liaison de tous les maxima locaux qui se situent sur une ligne est appelée ligne de crête (208).

3. Pale de rotor (108) selon la revendication 2, dans laquelle l'au moins un élément profilé (200), pour chaque rainure (230), présente
- une surface profilée, qui se trouve sur le côté racine de pale de rotor de la rainure (230) respective et s'étend entre la rainure (230) respective et la ligne de crête (208) qui se trouve sur le même côté profilé, directement sur le côté racine de pale de rotor de la rainure (230) respective, dans laquelle la surface profilée présente une épaisseur d'élément profilé diminuant en direction du côté de pointe de pale de rotor, et
- une surface profilée, qui se trouve sur le côté de pointe de pale de rotor de la rainure (230) respective et qui s'étend entre la rainure (230) respective et la ligne de crête (208) qui se trouve sur le même côté profilé directement sur le côté de pointe de pale de rotor de la rainure (230) respective, dans laquelle la surface profilée présente une épaisseur d'élément profilé augmentant en direction du côté de pointe de pale de rotor,
dans laquelle chaque surface profilée est réalisée de manière convexe, concave ou droite.

4. Pale de rotor (108) selon l'une quelconque des revendications 2 et 3, dans laquelle l'au moins un élément profilé (200) présente une première surface profilée sur le côté profilé côté pression (226) et/ou sur le côté profilé côté aspiration (218), en partant du côté de racine de pale de rotor, dans laquelle la première surface profilée présente une épaisseur d'élément profilé augmentant en direction du côté de pointe de pale de rotor et dans laquelle la première surface profilée atteint son épaisseur maximale d'élément profilé le long d'une première ligne de crête(208), qui s'étend parallèlement à la corde de profil,
dans laquelle chaque surface profilée est réalisée de manière convexe, concave ou droite.

5. Pale de rotor (108) selon l'une quelconque des revendications 2 à 4, dans laquelle l'au moins un élément profilé (200) présente une dernière surface profilée sur le côté profilé côté pression (226) et/ou sur le côté profilé côté aspiration (218), en partant du côté de racine de pale de rotor, jusqu'au côté de pointe de pale de rotor de la dernière ligne de crête (208), en direction du côté de pointe de pale de rotor, dans laquelle la dernière surface profilée présente une épaisseur d'élément profilé diminuant en direction de l'extrémité de pale de rotor et dans laquelle la dernière surface profilée atteint son épaisseur minimale d'élément profilé le long du bord de l'au moins un élément profilé (200),
dans laquelle chaque surface profilée est réalisée de manière convexe, concave ou droite.

6. Pale de rotor (108) selon l'une quelconque des revendications 3 à 5, dans laquelle chaque surface profilée de l'au moins un élément profilé (200) s'étend depuis une extrémité distale (202) vers une extrémité proximale (204) de l'au moins un élément profilé (200).

7. Pale de rotor (108) selon l'une quelconque des revendications 3 à 6, dans laquelle chaque surface profilée de l'au moins un élément profilé (200), qui est adjacente à une rainure (230), est réalisée de manière sensiblement congruente par rapport à la deuxième surface profilée, qui est adjacente à la même rainure (230).

8. Pale de rotor (108) selon l'une des revendications 2 à 7, dans laquelle au moins une ligne de crête (208) de l'au moins un élément profilé (200) présente un bord tranchant.

9. Pale de rotor (108) selon l'une quelconque des revendications 2 à 8, dans laquelle au moins une rainure (230) de l'au moins un élément profilé (200) présente un bord tranchant.

10. Pale de rotor (108) selon l'une quelconque des revendications 2 à 9, dans laquelle chaque ligne de crête (208, 224) et chaque rainure (230) du côté profilé côté pression (226) de l'au moins un élément profilé (200) sont disposées en chaque point perpendiculairement, par rapport à la direction de porte-à-faux (122), sous une ligne de crête respective et une rainure (230) respective du côté profilé côté aspiration (218) de l'au moins un élément profilé (200).

11. Pale de rotor (108) selon l'une quelconque des revendications précédentes, dans laquelle la section proximale (214) et la section distale (216) de l'au moins un élément profilé (200) sont réalisées à partir de plusieurs formes de pointe de flèche disposées parallèlement, dans laquelle chaque forme de pointe de flèche chevauche avec la ou les formes de pointe de flèche directement adjacentes et dans laquelle, pour chaque forme de pointe de flèche, l'extrémité proximale (204) et l'extrémité distale (202) sont réalisées respectivement sensiblement de manière ronde ou pointue.

12. Pale de rotor (108) selon l'une quelconque des revendications précédentes, dans laquelle une fente de fixation (206) est réalisée entre le côté profilé côté pression (226) et le côté profilé côté aspiration (218) dans la section proximale (214), dans laquelle la zone de bord de fuite (116) est disposée au moins en partie à l'intérieur de la fente de fixation (206).

13. Pale de rotor (108) selon l'une quelconque des revendications précédentes, dans laquelle l'au moins un élément profilé (200) est réalisé en deux parties, dans laquelle une première partie présente le côté profilé côté pression (226) et une deuxième partie présente le côté profilé côté aspiration (218), dans laquelle la première partie est fixée sur le côté pression (120) et la deuxième partie sur le côté aspiration (118), de préférence par collage, dans laquelle, de préférence, les sections en porte-à-faux par rapport au bord de fuite (114) de la première et de la deuxième partie sont fixées les unes aux autres, de préférence sont collées.

14. Pale de rotor (108) selon l'une quelconque des revendications précédentes, dans laquelle une épaisseur d'élément (D) est définie entre le côté profilé côté pression (226) et le côté profilé côté aspiration (218) de l'au moins un élément profilé (200), et l'épaisseur d'élément augmente de l'extrémité proximale (204) jusqu'à une épaisseur d'élément maximale sur un emplacement d'élément profilé, puis diminue dudit emplacement vers l'extrémité distale (202).

15. Pale de rotor (108) selon l'une quelconque des revendications précédentes, comprenant deux éléments profilés (200) ou plus, qui sont disposés l'un à côté de l'autre le long du bord de fuite (114) et se poussent.

16. Éolienne (100) avec une pale de rotor (108) selon l'une quelconque des revendications précédentes.

17. Parc éolien avec plusieurs éoliennes (100) selon la revendication 16.

18. Procédé d'optimisation d'une pale de rotor (108), dans lequel la pale de rotor (108) présente un bord d'attaque (112), un bord de fuite (114), un côté aspiration (118) et un côté pression (120) et s'étend dans une direction longitudinale de pale de rotor entre une extrémité de racine et une extrémité de pointe,
dans lequel une liaison directe entre le bord d'attaque (112) et le bord de fuite (114) est appelée corde de profil et dont la longueur est appelée profondeur de profil, comprenant :
- le montage d'au moins un élément profilé (200), dans lequel l'au moins un élément profilé (200) est disposé par une section proximale (214) sur une zone de bord de fuite (116) de manière adjacente au bord de fuite (114) et est en porte-à-faux par une section distale (216) par rapport au bord de fuite (114) avec une direction de porte-à-faux (122) qui est sensiblement parallèle à la direction de la profondeur de profil,
dans lequel l'au moins un élément profilé (200) présente une épaisseur d'élément profilé dans une direction perpendiculairement à la direction de porte-à-faux (122) entre un plan, qui est formé par le bord de fuite (114) et la direction de porte-à-faux (122), et la surface de l'au moins un élément profilé (200),
dans lequel l'au moins un élément profilé (200) présente un côté profilé côté pression (226) associé au côté pression (120) et un côté profilé côté aspiration (218) associé au côté aspiration (118),
dans laquelle l'au moins un élément profilé (200) présente une section transversale de manière sensiblement orthogonale par rapport à la direction de porte-à-faux (122),
dans lequel
la section transversale de l'au moins un élément profilé (200) présente au moins un minimum local de l'épaisseur d'élément profilé, dans lequel l'épaisseur d'élément profilé présente, dans la section transversale de part et d'autre du minimum local, une valeur plus grande,
la section proximale (214) et la section distale (216) de l'au moins un élément profilé (200) sont réalisées en forme de pointe de flèche, et l'extrémité proximale (204) et l'extrémité distale (202) sont respectivement réalisées de manière sensiblement ronde ou pointue, par exemple, l'extrémité proximale (204) est pointue et l'extrémité distale (202) est ronde, **caractérisé en ce que** le côté profilé côté pression (226) de l'au moins un élément profilé (200) est une réflexion, par rapport au plan formé par le bord de fuite (114) et la direction de porte-à-faux (122), du côté profilé côté aspiration (218).
